# EUROPEAN PATENT SPECIFICATION

(11) **EP 4 329 250 B1**
(45) Date of publication and mention of the grant of the patent: **21.01.2026**
(21) Application number: 21943032.9
(22) Date of filing: 27.05.2021
(51) Int. Cl.: H03M 7/00, H04L 13/00, H03M 7/28, H04N 21/236

(54) **INFORMATION BIT STREAM DISTRIBUTION DEVICE, INFORMATION BIT STREAM CONVERSION CIRCUIT, INFORMATION BIT STREAM DISTRIBUTION METHOD, INFORMATION BIT STREAM DECODING DEVICE, INFORMATION BIT STREAM INVERSE CONVERSION CIRCUIT, AND OPTICAL COMMUNICATION SYSTEM**
INFORMATIONSBITSTROMVERTEILUNGSVORRICHTUNG, INFORMATIONSBITSTROMUMWANDLUNGSSCHALTUNG, INFORMATIONSBITSTROMVERTEILUNGSVERFAHREN, INFORMATIONSBITSTROMDECODIERSCHALTUNG UND OPTISCHES KOMMUNIKATIONSSYSTEM
DISPOSITIF DISTRIBUTEUR, CIRCUIT CONVERTISSEUR, PROCÉDÉ DISTRIBUTEUR, DISPOSITIF DÉCODEUR ET CIRCUIT CONVERTISSEUR INVERSE DE FLUX BINAIRES D'INFORMATIONS, ET SYSTÈME OPTIQUE DE COMMUNICATION

(43) Date of publication of application: 28.02.2024
(73) Proprietor: MITSUBISHI ELECTRIC CORPORATION, Chiyoda-ku Tokyo 100-8310 (JP)
(72) Inventor: YOSHIDA, Tsuyoshi, Tokyo 100-8310 (JP)
(74) Representative: Plasseraud IP
(86) International application number: PCT/JP2021/020150
(87) International publication number: WO 2022/249382

(56) References cited:
- WO-A1-2020/031257
- WO-A1-2020/183525
- WO-A2-02/35906
- JP-A- 2001 197 028
- JP-A- 2003 037 644
- JP-A- 2018 049 363
- US-A1- 2013 129 350
- YU QINYANG ET AL: "FPGA Implementation of Rate-Adaptable Prefix-Free Code Distribution Matching for Probabilistic Constellation Shaping", JOURNAL OF LIGHTWAVE TECHNOLOGY, IEEE, USA, vol. 39, no. 4, 4 November 2020 (2020-11-04), pages 1072 - 1080, XP011836176, ISSN: 0733-8724, [retrieved on 20210204], DOI: 10.1109/JLT.2020.3035039

## Description

### TECHNICAL FIELD

The present disclosure relates to an information bit stream distribution device, an information bit stream conversion circuit, an information bit stream distribution method, an information bit stream decoding device, an information bit stream inverse conversion circuit, and an optical communication system.

### BACKGROUND ART

Among optical communication systems that transmit an information bit stream using an optical fiber, there is an optical communication system that divides an information bit stream into a plurality of information bit streams and carries the respective divided information bit streams by subcarriers different from each other (hereinafter, referred to as "conventional optical communication system"). The conventional optical communication system performs probabilistic shaping of signal point arrangement for transmission data included in an information bit stream carried by each subcarrier using a probability distribution.

By the way, as a technique for generating a plurality of probability distributions, a distribution matching circuit is disclosed in Non-Patent Literature 1. Document WO02/35906 discloses a system for transporting a high-speed data stream over a plurality of relatively low bandwidth unshielded twisted copper pairs

### CITATION LIST

### NON-PATENT LITERATURE

Non-Patent Literature 1: Q. Yu et al. "FPGA Implementation of Rate-Adaptable Prefix-Free Code Distribution Matching for Probabilistic Constellation Shaping", Journal of Lightwave Technology, DOI:10.1109/JLT.2020.3035039, 2020.

### SUMMARY OF INVENTION

### TECHNICAL PROBLEM

In the conventional optical communication system, there is a problem that a transmission speed of transmission data included in an information bit stream carried by each subcarrier cannot be changed.

If the distribution matching circuit disclosed in Non-Patent Literature 1 can be applied to the conventional optical communication system, the conventional optical communication system may be able to perform probabilistic shaping of signal point arrangement for transmission data included in information bit streams carried by subcarriers using probability distributions different from each other. However, in the conventional optical communication system, even if the probabilistic shaping as described above can be performed, a transmission speed of transmission data included in an information bit stream carried by each subcarrier cannot be changed.

The present disclosure has been made in order to solve the above problem, and an object of the present disclosure is to obtain an information bit stream conversion circuit and an information bit stream distribution method capable of changing a transmission speed of transmission data included in an information bit stream carried by each subcarrier.

### SOLUTION TO PROBLEM

An information bit stream conversion circuit according to the present disclosure is defined in the appended claims.

### ADVANTAGEOUS EFFECTS OF INVENTION

According to the present disclosure, a transmission speed of transmission data included in an information bit stream carried by each subcarrier can be changed.

### BRIEF DESCRIPTION OF DRAWINGS

FIG. 1 is a configuration diagram illustrating an information bit stream distribution device 1 according to a first example.
FIG. 2 is a hardware configuration diagram illustrating hardware of the information bit stream distribution device 1 according to the first example.
FIG. 3 is a hardware configuration diagram of a computer when the information bit stream distribution device 1 is implemented by software, firmware, or the like.
FIG. 4 is an explanatory diagram illustrating examples of an information bit stream, a first information bit stream, and a second information bit stream.
FIG. 5 is a flowchart illustrating an information bit stream distribution method which is a processing procedure performed in the information bit stream distribution device 1.
FIG. 6 is a configuration diagram illustrating a second bit stream output unit 12 implemented by a lane shift selector.
FIG. 7 is a configuration diagram illustrating an information bit stream distribution device 3 according to a second example.
FIG. 8 is an explanatory diagram illustrating examples of an information bit stream, a first information bit stream, a second information bit stream, a third information bit stream, a fourth information bit stream, a fifth information bit stream, and a sixth information bit stream.
FIG. 9 is a configuration diagram illustrating an information bit stream distribution device 4 according to a third example.
FIG. 10 is an explanatory diagram illustrating examples of an information bit stream, a first information bit stream, a second information bit stream, a seventh information bit stream, an eighth information bit stream, a ninth information bit stream, and a tenth information bit stream.
FIG. 11 is a configuration diagram illustrating an information bit stream conversion circuit 30 according to a first embodiment of the invention.
FIG. 12 is a configuration diagram illustrating an information bit stream decoding device 50 according to a second embodiment of the invention.
FIG. 13 is a hardware configuration diagram illustrating hardware of the information bit stream decoding device 50 according to the second embodiment of the invention.
FIG. 14 is a hardware configuration diagram of a computer when the information bit stream decoding device 50 is implemented by software, firmware, or the like.
FIG. 15 is an explanatory diagram illustrating examples of an information bit stream, a first information bit stream, and a second information bit stream.
FIG. 16 is a flowchart illustrating an information bit stream decoding method which is a processing procedure performed in the information bit stream decoding device 50.
FIG. 17 is a configuration diagram illustrating an information bit stream decoding device 53 according to a third embodiment of the invention.
FIG. 18 is a configuration diagram illustrating an information bit stream decoding device 54 according to a fourth embodiment.
FIG. 19 is a configuration diagram illustrating an information bit stream inverse conversion circuit 60 according to an fifth embodiment.
FIG. 20 is a configuration diagram illustrating an optical communication system according to a sixth embodiment.
FIG. 21 is a configuration diagram illustrating the inside of a transmission signal processing circuit 71.
FIG. 22 is a configuration diagram illustrating the inside of a reception signal processing circuit 94.

### DESCRIPTION OF EMBODIMENTS

Hereinafter, in order to describe the present disclosure in more detail, embodiments for carrying out the present disclosure will be described with reference to the attached drawings. Before that, examples not forming part of the present invention will be presented to disclose aspects useful to understand the present invention.

### First Example.

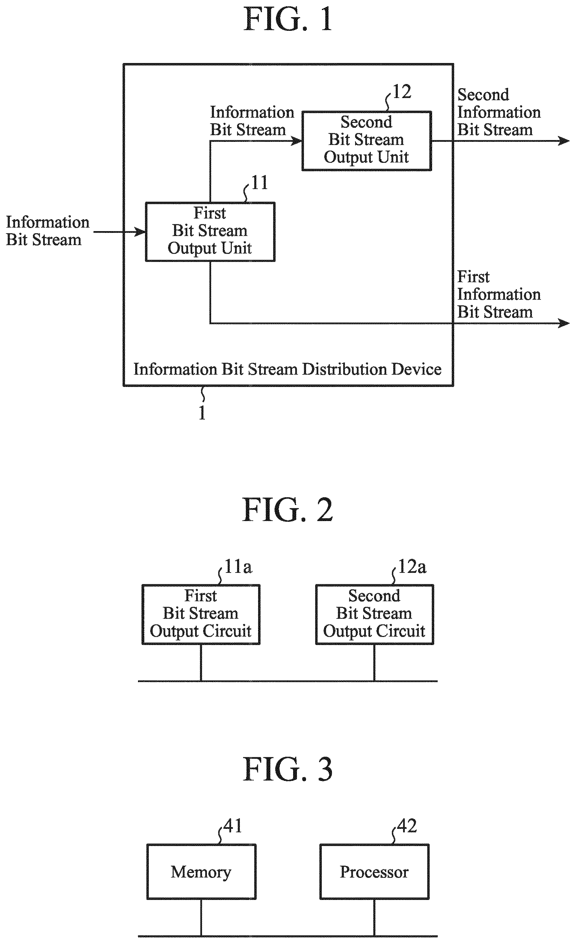

FIG. 1 is a configuration diagram illustrating an information bit stream distribution device 1 according to a first example.

FIG. 2 is a hardware configuration diagram illustrating hardware of the information bit stream distribution device 1 according to the first example.

The information bit stream distribution device 1 illustrated in FIG. 1 includes a first bit stream output unit 11 and a second bit stream output unit 12.

The first bit stream output unit 11 is implemented by, for example, a first bit stream output circuit 11a illustrated in FIG. 2.

The first bit stream output unit 11 acquires an information bit stream supplied from the outside. The information bit stream has a valid bit stream including transmission data and an invalid bit stream including dummy data. The dummy data includes one or more invalid bits, and each of the invalid bits may be fixed to 0 or may be fixed to 1. In addition, each of the invalid bits may be don't care.

The first bit stream output unit 11 extracts, from the transmission data included in the valid bit stream of the information bit stream, some pieces of transmission data as first transmission data.

The first bit stream output unit 11 outputs an information bit stream having a valid bit stream including the first transmission data and an invalid bit stream including dummy data to the outside as a first information bit stream in which the first transmission data is transmitted at a first speed.

The first bit stream output unit 11 outputs the acquired information bit stream to the second bit stream output unit 12.

The second bit stream output unit 12 is implemented by, for example, a second bit stream output circuit 12a illustrated in FIG. 2.

The second bit stream output unit 12 extracts, from the transmission data included in the valid bit stream of the information bit stream acquired by the first bit stream output unit 11, transmission data other than the first transmission data as second transmission data.

The second bit stream output unit 12 outputs an information bit stream having a valid bit stream including the second transmission data and an invalid bit stream including dummy data to the outside as a second information bit stream in which the second transmission data is transmitted at a second speed.

In FIG. 1, it is assumed that each of the first bit stream output unit 11 and the second bit stream output unit 12, which are constituent elements of the information bit stream distribution device 1, is implemented by dedicated hardware as illustrated in FIG. 2. That is, it is assumed that the information bit stream distribution device 1 is implemented by the first bit stream output circuit 11a and the second bit stream output circuit 12a.

For example, a single circuit, a composite circuit, a programmed processor, a parallel programmed processor, an application specific integrated circuit (ASIC), a field-programmable gate array (FPGA), or a combination thereof corresponds to each of the first bit stream output circuit 11a and the second bit stream output circuit 12a.

The constituent elements of the information bit stream distribution device 1 are not limited to those implemented by dedicated hardware, and the information bit stream distribution device 1 may be implemented by software, firmware, or a combination of software and firmware.

Software or firmware is stored as a program in a memory of a computer. The computer means hardware for executing a program. To the computer, for example, a central processing unit (CPU), a central processing device, a processing device, an arithmetic device, a microprocessor, a microcomputer, a processor, or a digital signal processor (DSP) corresponds.

FIG. 3 is a hardware configuration diagram of a computer when the information bit stream distribution device 1 is implemented by software, firmware, or the like.

When the information bit stream distribution device 1 is implemented by software, firmware, or the like, a program for causing a computer to execute processing procedures in each of the first bit stream output unit 11 and the second bit stream output unit 12 is stored in a memory 41. A processor 42 of the computer executes the program stored in the memory 41.

FIG. 2 illustrates an example in which each of the constituent elements of the information bit stream distribution device 1 is implemented by dedicated hardware, and FIG. 3 illustrates an example in which the information bit stream distribution device 1 is implemented by software, firmware, or the like. However, this is merely an example, and some constituent elements in the information bit stream distribution device 1 may be implemented by dedicated hardware, and the remaining constituent elements may be implemented by software, firmware, or the like.

Next, an operation of the information bit stream distribution device 1 illustrated in FIG. 1 will be described.

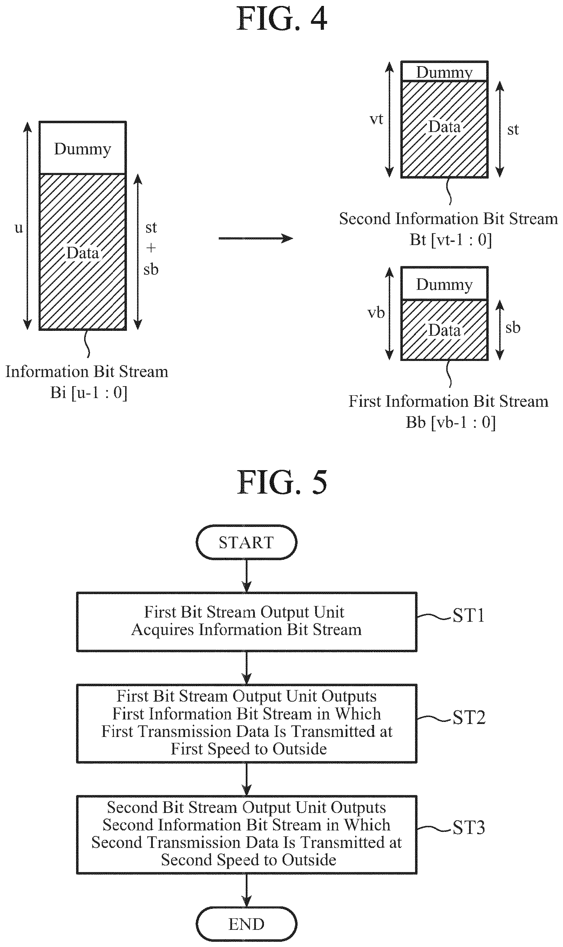

FIG. 4 is an explanatory diagram illustrating examples of the information bit stream, the first information bit stream, and the second information bit stream.

FIG. 5 is a flowchart illustrating an information bit stream distribution method which is a processing procedure performed in the information bit stream distribution device 1.

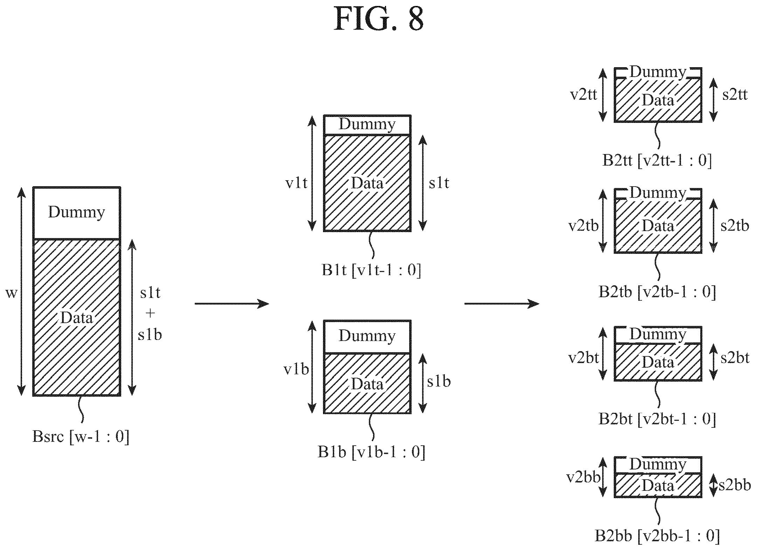

The information bit stream supplied to the information bit stream distribution device 1 is represented by Bi[u-1:0] as illustrated in FIG. 4. In FIG. 4, "data" represents transmission data, and "dummy" represents dummy data. Also in FIG. 8 and the like described later, similar illustration is made.

The number of bits of the information bit stream Bi[u-1:0] is u. u is a natural number.

The information bit stream Bi[u-1:0] has a valid bit stream Bi[sb+st-1:0] and an invalid bit stream Bi[u-1:sb+st]. The number of bits of the valid bit stream Bi[sb+st-1:0] is sb + st, and the number of bits of the invalid bit stream Bi[u-1:sb+st] is u- (st + sb). 0 ≤ sb + st ≤ u is satisfied. sb and st are non-negative integers.

The valid bit stream Bi[sb+st-1:0] includes transmission data. Some pieces of the transmission data are the first transmission data, and transmission data other than the first transmission data in the transmission data is the second transmission data. The number of bits of the first transmission data is sb, and the number of bits of the second transmission data is st.

The number of bits sb of the first transmission data is determined according to the first speed at which the first transmission data is transmitted. The number of bits sb increases as the first speed increases.

The number of bits st of the second transmission data is determined according to the second speed at which the second transmission data is transmitted. The number of bits st increases as the second speed increases.

As illustrated in FIG. 4, the first information bit stream is represented by Bb[vb-1:0].

The number of bits of the first information bit stream is vb. vb is a natural number.

The first information bit stream Bb[vb-1:0] has a valid bit stream Bb[sb-1:0] and an invalid bit stream Bb[vb-1:sb]. The valid bit stream Bb[sb-1:0] includes the first transmission data, and the number of bits of the valid bit stream Bb[sb-1:0] is sb. The invalid bit stream Bb[vb-1:sb] includes dummy data, and the number of bits of the invalid bit stream Bb[vb-1:sb] is vb - sb.

As illustrated in FIG. 4, the second information bit stream is represented by Bt[vt-1:0].

The number of bits of the second information bit stream is vt. vt is a natural number.

The second information bit stream Bt[vt-1:0] has a valid bit stream Bt[st-1:0] and an invalid bit stream Bt[vt-1:st]. The valid bit stream Bt[st-1:0] includes the second transmission data, and the number of bits of the valid bit stream Bt[st-1:0] is st. The invalid bit stream Bt[vt-1:st] includes dummy data, and the number of bits of the invalid bit stream Bt[vt-1:st] is vt - st.

In the example of FIG. 4, in the valid bit stream Bi[sb+st-1:0] of the information bit stream Bi[u-1:0], the first transmission data is disposed on a low-order bit side, and the second transmission data is disposed on a high-order bit side. However, this is merely an example, and in the valid bit stream Bi[sb+st-1:0], the first transmission data may be disposed on a high-order bit side, and the second transmission data may be disposed on a low-order bit side.

In addition, in the example of FIG. 4, in the information bit stream Bi[u-1:0], the valid bit stream Bi[sb+st-1:0] is disposed on a low-order bit side, and the invalid bit stream Bi[u-1:sb+st] is disposed on a high-order bit side. However, this is merely an example, and the information bit stream Bi[u-1:0], the valid bit stream may be disposed on a high-order bit side, and the invalid bit stream may be disposed on a low-order bit side.

The first bit stream output unit 11 acquires the information bit stream Bi[u-1:0] supplied from the outside (step ST1 in FIG. 5).

The first bit stream output unit 11 extracts, from transmission data included in the valid bit stream Bi[sb+st-1:0] of the information bit stream Bi[u-1:0], some pieces of transmission data as the first transmission data.

That is, the first bit stream output unit 11 extracts, from transmission data included in the valid bit stream Bi[sb+st-1:0], a bit stream of Bi[sb-1:0] as the first transmission data.

The number of bits sb of the first transmission data may be stored in an internal memory of the first bit stream output unit 11 or may be supplied from the outside of the information bit stream distribution device 1.

The first bit stream output unit 11 extracts, from dummy data included in the invalid bit stream Bi[u-1:sb+st] of the information bit stream Bi[u-1:0], some pieces of dummy data as first dummy data.

That is, the first bit stream output unit 11 extracts, from data included in the invalid bit stream Bi[u-1:sb+st], a bit stream of Bi[sb+st+(vb-sb)-1:sb+st] as the first dummy data.

Each of the number of bits st of the second transmission data and the number of bits vb of the first information bit stream may be stored in the internal memory of the first bit stream output unit 11 or may be supplied from the outside of the information bit stream distribution device 1.

The first bit stream output unit 11 generates the first information bit stream Bb[vb-1:0] in which the first transmission data is transmitted at the first speed.

That is, the first bit stream output unit 11 generates the first information bit stream Bb[vb-1:0] having the valid bit stream Bb[sb-1:0] including the extracted first transmission data and the invalid bit stream Bb[vb-1:sb] including the extracted first dummy data.

The first speed at which the first transmission data is transmitted is represented by sb/vb, and the higher a ratio of the number of bits sb of the first transmission data to the number of bits vb of the first information bit stream, the higher the first speed.

The first bit stream output unit 11 outputs the first information bit stream Bb[vb-1:0] in which the first transmission data is transmitted at the first speed to the outside (step ST2 in FIG. 5).

In addition, the first bit stream output unit 11 outputs the acquired information bit stream Bi[u-1:0] to the second bit stream output unit 12.

The second bit stream output unit 12 acquires the information bit stream Bi[u-1:0] from the first bit stream output unit 11.

The second bit stream output unit 12 extracts, from transmission data included in the valid bit stream Bi[sb+st-1:0] of the information bit stream Bi[u-1:0], transmission data other than the first transmission data as the second transmission data.

That is, the second bit stream output unit 12 extracts, from transmission data included in the valid bit stream Bi[sb+st-1:0], a bit stream of Bi[sb+st-1:sb] as the second transmission data.

Each of the number of bits sb of the first transmission data and the number of bits st of the second transmission data may be stored in an internal memory of the second bit stream output unit 12 or may be supplied from the outside of the information bit stream distribution device 1.

The second bit stream output unit 12 extracts, from dummy data included in the invalid bit stream Bi[u-1:sb+st] of the information bit stream Bi[u-1:0], dummy data other than the first dummy data as second dummy data.

That is, the second bit stream output unit 12 extracts, from dummy data included in the invalid bit stream Bi[u-1:sb+st], a bit stream of Bi[u-1:sb+st+(vb-sb)] as the second dummy data.

The number of bits vb of the first information bit stream may be stored in the internal memory of the second bit stream output unit 12 or may be supplied from the outside of the information bit stream distribution device 1.

The second bit stream output unit 12 generates the second information bit stream Bt[vt-1:0] in which the second transmission data is transmitted at the second speed.

That is, the second bit stream output unit 12 generates the second information bit stream Bt[vt-1:0] having the valid bit stream Bt[st-1:0] including the extracted second transmission data and the invalid bit stream Bt[vt-1:st] including the extracted second dummy data.

The second speed at which the second transmission data is transmitted is represented by st/vt, and the higher a ratio of the number of bits st of the second transmission data to the number of bits vt of the second information bit stream, the higher the second speed.

The second bit stream output unit 12 outputs the second information bit stream Bt[vt-1:0] in which the second transmission data is transmitted at the second speed to the outside (step ST3 in FIG. 5).

For example, assuming that vb = vt = v is satisfied, the information bit stream distribution device 1 illustrated in FIG. 1 can divide the transmission data included in the valid bit stream of the information bit stream into the first transmission data having the number of bits proportional to the first speed sb/v and the second transmission data having the number of bits proportional to the second speed st/v, and can distribute the first transmission data and the second transmission data to two respective subcarriers. Note that vb = vt does not have to be satisfied, and vb ≠ vt may be satisfied.

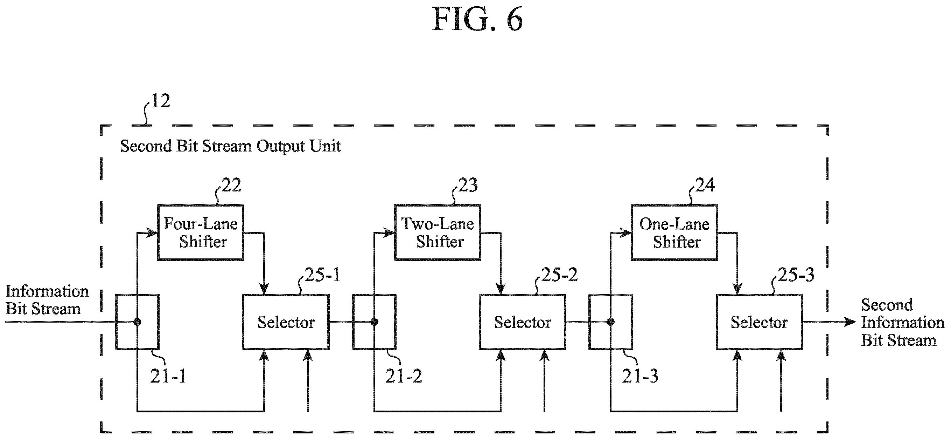

In the information bit stream distribution device 1 illustrated in FIG. 1, the second bit stream output unit 12 implemented by the second bit stream output circuit 12a illustrated in FIG. 2 is illustrated. However, this is merely an example, and the second bit stream output unit 12 may be implemented by a lane shift selector as illustrated in FIG. 6.

FIG. 6 is a configuration diagram illustrating the second bit stream output unit 12 implemented by a lane shift selector.

The second bit stream output unit 12 illustrated in FIG. 6 includes branching units 21-1, 21-2, and 21-3, a four-lane shifter 22, a two-lane shifter 23, a one-lane shifter 24, and selectors 25-1, 25-2, and 25-3.

The branching unit 21-1 outputs the information bit stream Bi[u-1:0] output from the first bit stream output unit 11 to each of the four-lane shifter 22 and the selector 25-1.

The four-lane shifter 22 shifts the information bit stream Bi[u-1:0] output from the branching unit 21-1 to a 4-lane low-order digit side.

The four-lane shifter 22 outputs the shifted information bit stream to the selector 25-1.

The selector 25-1 selects either the information bit stream output from the branching unit 21-1 or the shifted information bit stream output from the four-lane shifter 22 on the basis of, for example, a control signal supplied from the outside of the information bit stream distribution device 1.

The selector 25-1 outputs the selected information bit stream to the branching unit 21-2.

The branching unit 21-2 outputs the information bit stream output from the selector 25-1 to each of the two-lane shifter 23 and the selector 25-2.

The two-lane shifter 23 shifts the information bit stream output from the branching unit 21-2 to a 2-lane low-order digit side.

The two-lane shifter 23 outputs the shifted information bit stream to the selector 25-2.

The selector 25-2 selects either the information bit stream output from the branching unit 21-2 or the shifted information bit stream output from the two-lane shifter 23 on the basis of, for example, a control signal supplied from the outside of the information bit stream distribution device 1.

The selector 25-2 outputs the selected information bit stream to the branching unit 21-3.

The branching unit 21-3 outputs the information bit stream output from the selector 25-2 to each of the one-lane shifter 24 and the selector 25-3.

The one-lane shifter 24 shifts the information bit stream output from the branching unit 21-3 to a 1-lane low-order digit side.

The one-lane shifter 24 outputs the shifted information bit stream to the selector 25-3.

The selector 25-3 selects either the information bit stream output from the branching unit 21-3 or the shifted information bit stream output from the one-lane shifter 24 on the basis of, for example, a control signal supplied from the outside of the information bit stream distribution device 1.

The selector 25-3 outputs the selected information bit stream to the outside as the second information bit stream Bt[vt-1:0].

The second bit stream output unit 12 illustrated in FIG. 6 can shift any number of bits out of 0 to seven bits.

For example, when a five-bit shift of the information bit stream Bi[u-1:0] is implemented, the following control signal is supplied to the second bit stream output unit 12 from the outside of the information bit stream distribution device 1.

The selector 25-1 selects the shifted information bit stream output from the four-lane shifter 22, the selector 25-2 selects the information bit stream output from the branching unit 21-2, and a control signal instructing that the selector 25-3 selects the shifted information bit stream output from the one-lane shifter 24 is supplied to the second bit stream output unit 12.

For example, when a 3-bit shift of the information bit stream Bi[u-1:0] is implemented, the following control signal is supplied to the second bit stream output unit 12 from the outside of the information bit stream distribution device 1.

The selector 25-1 selects the information bit stream output from the branching unit 21-1, the selector 25-2 selects the shifted information bit stream output from the two-lane shifter 23, and a control signal instructing that the selector 25-3 selects the shifted information bit stream output from the one-lane shifter 24 is supplied to the second bit stream output unit 12.

In the above first embodiment, the information bit stream distribution device 1 includes: the first bit stream output unit 11 that acquires an information bit stream having a valid bit stream including transmission data and an invalid bit stream including dummy data, extracts, from the transmission data included in the valid bit stream of the information bit stream, some pieces of transmission data as first transmission data, and outputs an information bit stream having a valid bit stream including the first transmission data and an invalid bit stream including dummy data as a first information bit stream in which the first transmission data is transmitted at a first speed; and the second bit stream output unit 12 that extracts, from the transmission data included in the valid bit stream of the information bit stream acquired by the first bit stream output unit 11, some pieces of transmission data other than the first transmission data as second transmission data, and outputs an information bit stream having a valid bit stream including the second transmission data and an invalid bit stream including dummy data as a second information bit stream in which the second transmission data is transmitted at a second speed. Therefore, the information bit stream distribution device 1 can change a transmission speed of transmission data included in an information bit stream carried by each subcarrier.

### Second Example.

In a second embodiment, an information bit stream distribution device 3 including three information bit stream distribution devices 1 illustrated in FIG. 1 will be described.

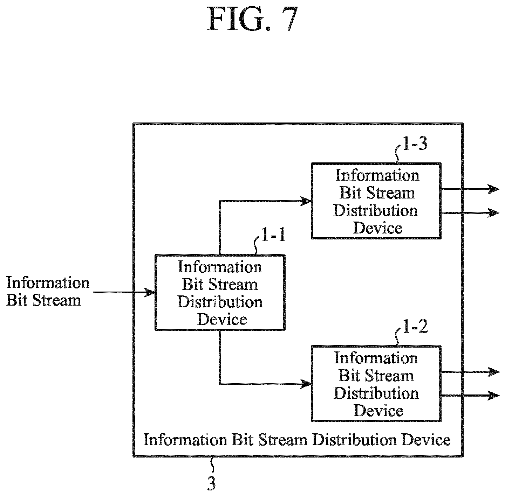

FIG. 7 is a configuration diagram illustrating the information bit stream distribution device 3 according to the second example.

The information bit stream distribution device 3 illustrated in FIG. 7 includes information bit stream distribution devices 1-1, 1-2, and 1-3.

Each of the information bit stream distribution devices 1-1, 1-2, and 1-3 is the same information bit stream distribution device as the information bit stream distribution device 1 illustrated in FIG. 1.

Among the three information bit stream distribution devices, the first information bit stream distribution device 1-1 acquires an information bit stream.

The first information bit stream distribution device 1-1 outputs a first information bit stream to the second information bit stream distribution device 1-2, and outputs a second information bit stream to the third information bit stream distribution device 1-3.

The second information bit stream distribution device 1-2 acquires the first information bit stream output from the information bit stream distribution device 1-1.

The information bit stream distribution device 1-2 extracts, from first transmission data included in a valid bit stream of the first information bit stream, some pieces of transmission data as third transmission data.

The information bit stream distribution device 1-2 outputs an information bit stream having a valid bit stream including the third transmission data and an invalid bit stream including dummy data to the outside as a third information bit stream in which the third transmission data is transmitted at a third speed.

In addition, the information bit stream distribution device 1-2 extracts, from the first transmission data included in the valid bit stream of the first information bit stream, transmission data other than the third transmission data as fourth transmission data.

The information bit stream distribution device 1-2 outputs an information bit stream having a valid bit stream including the fourth transmission data and an invalid bit stream including dummy data to the outside as a fourth information bit stream in which the fourth transmission data is transmitted at a fourth speed.

The third information bit stream distribution device 1-3 acquires the second information bit stream output from the information bit stream distribution device 1-1.

The information bit stream distribution device 1-3 extracts, from the second transmission data included in the valid bit stream of the second information bit stream, some pieces of transmission data as fifth transmission data.

The information bit stream distribution device 1-3 outputs an information bit stream having a valid bit stream including the fifth transmission data and an invalid bit stream including dummy data to the outside as a fifth information bit stream in which the fifth transmission data is transmitted at a fifth speed.

In addition, the information bit stream distribution device 1-3 extracts, from the second transmission data included in the valid bit stream of the second information bit stream, transmission data other than the fifth transmission data as sixth transmission data.

The information bit stream distribution device 1-3 outputs an information bit stream having a valid bit stream including the sixth transmission data and an invalid bit stream including dummy data to the outside as a sixth information bit stream in which the sixth transmission data is transmitted at a sixth speed.

Next, an operation of the information bit stream distribution device 3 illustrated in FIG. 7 will be described.

FIG. 8 is an explanatory diagram illustrating examples of the information bit stream, the first information bit stream, the second information bit stream, the third information bit stream, the fourth information bit stream, the fifth information bit stream, and the sixth information bit stream.

As illustrated in FIG. 8, a first bit stream output unit 11 of the information bit stream distribution device 1-1 acquires an information bit stream Bsrc[w-1:0] from the outside. The number of bits of the information bit stream Bsrc[w-1:0] is w. w is a natural number.

The first bit stream output unit 11 of the information bit stream distribution device 1-1 extracts, from transmission data included in a valid bit stream Bsrc[s1b+s1t-1:0] of the information bit stream Bsrc[w-1:0], some pieces of transmission data as first transmission data. s1b and s1t are non-negative integers.

That is, the first bit stream output unit 11 extracts, from the transmission data included in the valid bit stream Bsrc[s1b+s1t-1:0], a bit stream of Bsrc[s1b-1:0] as the first transmission data.

The number of bits s1b of the first transmission data may be stored in an internal memory of the first bit stream output unit 11 or may be supplied from the outside of the information bit stream distribution device 1-1.

The first bit stream output unit 11 of the information bit stream distribution device 1-1 extracts, from dummy data included in an invalid bit stream Bsrc[w-1:s1b+s1t] of the information bit stream Bsrc[w-1:0], some pieces of dummy data as first dummy data.

That is, the first bit stream output unit 11 extracts, from the dummy data included in the invalid bit stream Bsrc[w-1:s1b+s1t], a bit stream of Bsrc[s1b+s1t+(v1b-s1b)-1:s1b+s1t] as the first dummy data.

Each of the number of bits s1t of the second transmission data and the number of bits v1b of the first information bit stream B1b[v1b-1:0] may be stored in the internal memory of the first bit stream output unit 11 or may be supplied from the outside of the information bit stream distribution device 1-1.

The first bit stream output unit 11 of the information bit stream distribution device 1-1 generates a first information bit stream B1b[v1b-1:0] in which the first transmission data is transmitted at a first speed.

That is, the first bit stream output unit 11 generates the first information bit stream B1b[v1b-1:0] having the valid bit stream B1b[s1b-1:0] including the extracted first transmission data and the invalid bit stream B1b[v1b-1:s1b] including the extracted first dummy data.

The first speed at which the first transmission data is transmitted is represented by s1b/v1b, and the higher a ratio of the number of bits s1b of the first transmission data to the number of bits v1b of the first information bit stream, the higher the first speed.

The first bit stream output unit 11 of the information bit stream distribution device 1-1 outputs the first information bit stream B1b[v1b-1:0] in which the first transmission data is transmitted at the first speed to the information bit stream distribution device 1-2.

The first bit stream output unit 11 of the information bit stream distribution device 1-1 outputs the acquired information bit stream Bsrc[w-1:0] to a second bit stream output unit 12.

The second bit stream output unit 12 of the information bit stream distribution device 1-1 acquires the information bit stream Bsrc[w-1:0] from the first bit stream output unit 11.

The second bit stream output unit 12 extracts, from the transmission data included in the valid bit stream Bsrc[s1b+s1t-1:0] of the information bit stream Bsrc[w-1:0], transmission data other than the first transmission data as second transmission data.

That is, the second bit stream output unit 12 extracts, from the transmission data included in the valid bit stream Bsrc[s1b+s1t-1:0], a bit stream of Bsrc[slb+sit-1:s1b] as the second transmission data.

Each of the number of bits s1b of the first transmission data and the number of bits s1t of the second transmission data may be stored in an internal memory of the second bit stream output unit 12 or may be supplied from the outside of the information bit stream distribution device 1-1.

The second bit stream output unit 12 of the information bit stream distribution device 1-1 extracts, from the dummy data included in the invalid bit stream Bsrc[w-1:s1b+s1t] of the information bit stream Bsrc[w-1:0], dummy data other than the first dummy data as second dummy data.

That is, the second bit stream output unit 12 extracts, from the dummy data included in the invalid bit stream Bsrc[w-1:s1b+s1t], a bit stream of Bsrc[w-1:s1b+s1t+(v1b-s1b)] as the second dummy data.

The number of bits v1b of the first information bit stream may be stored in the internal memory of the second bit stream output unit 12 or may be supplied from the outside of the information bit stream distribution device 1-1.

The second bit stream output unit 12 of the information bit stream distribution device 1-1 generates a second information bit stream B1t[v1t-1:0] in which the second transmission data is transmitted at a second speed.

That is, the second bit stream output unit 12 generates the second information bit stream B1t[v1t-1:0] having the valid bit stream B1t[s1t-1:0] including the extracted second transmission data and the invalid bit stream B1t[v1t-1:s1t] including the extracted second dummy data.

The second speed at which the second transmission data is transmitted is represented by s1t/v1t, and the higher a ratio of the number of bits s1t of the second transmission data to the number of bits v1t of the second information bit stream, the higher the second speed.

The second bit stream output unit 12 of the information bit stream distribution device 1-1 outputs the second information bit stream B1t[v1t-1:0] in which the second transmission data is transmitted at the second speed to the information bit stream distribution device 1-3.

The first bit stream output unit 11 of the information bit stream distribution device 1-2 acquires the first information bit stream B1b[v1b-1:0] from the information bit stream distribution device 1-1.

The first bit stream output unit 11 of the information bit stream distribution device 1-2 extracts, from the first transmission data included in the valid bit stream B1b[slb-1:0] of the first information bit stream B1b[v1b-1:0], some pieces of transmission data as third transmission data. s1b = s2bb + s2bt is satisfied, and s2bb and s2bt are non-negative integers.

That is, the first bit stream output unit 11 extracts, from the first transmission data included in the valid bit stream B1b[slb-1:0], a bit stream of B1b[s2bb-1:0] as the third transmission data.

The number of bits s2bb of the third transmission data may be stored in the internal memory of the first bit stream output unit 11 or may be supplied from the outside of the information bit stream distribution device 1-2.

The first bit stream output unit 11 of the information bit stream distribution device 1-2 extracts, from the first dummy data included in the invalid bit stream B1b[v1b-1:s1b] of the first information bit stream B1b[v1b-1:0], some pieces of dummy data as third dummy data.

That is, the first bit stream output unit 11 extracts, from the first dummy data included in the invalid bit stream B1b[v1b-1:s1b], a bit stream of B1b[s1b+(v2bb-s2bb)-1:s1b] as the third dummy data.

Each of the number of bits s1b of the first transmission data and the number of bits v2bb of a third information bit stream B2bb[v2bb-1:0] may be stored in the internal memory of the first bit stream output unit 11 or may be supplied from the outside of the information bit stream distribution device 1-2.

The first bit stream output unit 11 of the information bit stream distribution device 1-2 generates the third information bit stream B2bb[v2bb-1:0] in which the third transmission data is transmitted at a third speed.

That is, the first bit stream output unit 11 generates the third information bit stream B2bb[v2bb-1:0] having the valid bit stream B2bb[s2bb-1:0] including the extracted third transmission data and the invalid bit stream B2bb[v2bb-1:s2bb] including the extracted third dummy data.

The third speed at which the third transmission data is transmitted is represented by s2bb/v2bb, and the higher a ratio of the number of bits s2bb of the third transmission data to the number of bits v2bb of the third information bit stream, the higher the third speed.

The first bit stream output unit 11 of the information bit stream distribution device 1-2 outputs the third information bit stream B2bb[v2bb-1:0] in which the third transmission data is transmitted at the third speed to the outside.

The first bit stream output unit 11 of the information bit stream distribution device 1-2 outputs the acquired first information bit stream B1b[v1b-1:0] to a second bit stream output unit 12.

The second bit stream output unit 12 of the information bit stream distribution device 1-2 acquires the first information bit stream B1b[v1b-1:0] from the first bit stream output unit 11.

The second bit stream output unit 12 extracts, from the first transmission data included in the valid bit stream B1b[s1b-1:0] of the first information bit stream B1b[v1b-1:0], transmission data other than the first transmission data as fourth transmission data.

That is, the first bit stream output unit 11 extracts, from the first transmission data included in the valid bit stream B1b[slb-1:0], a bit stream of B1b[s1b-1:s2bb] as the fourth transmission data.

Each of the number of bits s1b of the first transmission data and the number of bits s2bb of the third transmission data may be stored in an internal memory of the second bit stream output unit 12 or may be supplied from the outside of the information bit stream distribution device 1-2.

The second bit stream output unit 12 of the information bit stream distribution device 1-2 extracts, from the first dummy data included in the invalid bit stream B1b[v1b-1:s1b] of the first information bit stream B1b[v1b-1:0], dummy data other than the third dummy data as fourth dummy data.

That is, the second bit stream output unit 12 extracts, from the first dummy data included in the invalid bit stream B1b[v1b-1:s1b], a bit stream of B1b[v1b-1:s1b+(v2bb-s2bb)] as the fourth dummy data.

The number of bits v2bb of the third information bit stream B2bb[v2bb-1:0] may be stored in the internal memory of the second bit stream output unit 12 or may be supplied from the outside of the information bit stream distribution device 1-2.

The second bit stream output unit 12 of the information bit stream distribution device 1-2 generates a fourth information bit stream B2bt[v2bt-1:0] in which the fourth transmission data is transmitted at a fourth speed.

That is, the second bit stream output unit 12 generates the fourth information bit stream B2bt[v2bt-1:0] having the valid bit stream B2bt[s2bt-1:0] including the extracted fourth transmission data and the invalid bit stream B2bt[v2bt-1:s2bt] including the extracted fourth dummy data.

The fourth speed at which the fourth transmission data is transmitted is represented by s2bt/v2bt, and the higher a ratio of the number of bits s2bt of the fourth transmission data to the number of bits v2bt of the fourth information bit stream, the higher the fourth speed.

The second bit stream output unit 12 of the information bit stream distribution device 1-2 outputs the fourth information bit stream B2bt[v2bt-1:0] in which the fourth transmission data is transmitted at the fourth speed to the outside.

A first bit stream output unit 11 of the information bit stream distribution device 1-3 acquires a second information bit stream B1t[v1t-1:0] from the information bit stream distribution device 1-1.

The first bit stream output unit 11 of the information bit stream distribution device 1-3 extracts, from second transmission data included in the valid bit stream B1t[s1t-1:0] of the second information bit stream B1t[v1t-1:0], some pieces of transmission data as fifth transmission data. s1t = s2tb + s2tt is satisfied, and s2tb and s2tt are non-negative integers.

That is, the first bit stream output unit 11 extracts, from the second transmission data included in the valid bit stream B1t[s1t-1:0], a bit stream of B1t[s2tb-1:0] as the fifth transmission data.

The number of bits s2tb of the fifth transmission data may be stored in an internal memory of the first bit stream output unit 11 or may be supplied from the outside of the information bit stream distribution device 1-3.

The first bit stream output unit 11 of the information bit stream distribution device 1-3 extracts, from the second dummy data included in the invalid bit stream B1t[v1t-1:s1t] of the second information bit stream B1t[v1t-1:0], some pieces of dummy data as fifth dummy data.

That is, the first bit stream output unit 11 extracts, from the second dummy data included in the invalid bit stream B1t[v1t-1:s1t], a bit stream of B1t[s1t+(v2tb-s2tb)-1:s1t] as the fifth dummy data.

Each of the number of bits s1t of the second transmission data and the number of bits v2tb of the fifth information bit stream B2tb[v2tb-1:0] may be stored in the internal memory of the first bit stream output unit 11 or may be supplied from the outside of the information bit stream distribution device 1-3.

The first bit stream output unit 11 of the information bit stream distribution device 1-3 generates a fifth information bit stream B2tb[v2tb-1:0] in which the fifth transmission data is transmitted at a fifth speed.

That is, the first bit stream output unit 11 generates the fifth information bit stream B2tb[v2tb-1:0] having the valid bit stream B2tb[s2tb-1:0] including the extracted fifth transmission data and the invalid bit stream B2tb[v2tb-1:s2tb] including the extracted fifth dummy data.

The fifth speed at which the fifth transmission data is transmitted is represented by s2tb/v2tb, and the higher a ratio of the number of bits s2tb of the fifth transmission data to the number of bits v2tb of the fifth information bit stream, the higher the fifth speed.

The first bit stream output unit 11 of the information bit stream distribution device 1-3 outputs the fifth information bit stream B2tb[v2tb-1:0] in which the fifth transmission data is transmitted at the fifth speed to the outside.

The first bit stream output unit 11 of the information bit stream distribution device 1-3 outputs the acquired second information bit stream B1t[v1t-1:0] to a second bit stream output unit 12.

The second bit stream output unit 12 of the information bit stream distribution device 1-3 acquires the second information bit stream B1t[v1t-1:0] from the first bit stream output unit 11.

The second bit stream output unit 12 extracts, from the second transmission data included in the valid bit stream B1t[s1t-1:0] of the second information bit stream B1t[v1t-1:0], transmission data other than the fifth transmission data as sixth transmission data.

That is, the first bit stream output unit 11 extracts, from the second transmission data included in the valid bit stream B1t[s1t-1:0], a bit stream of B1t[s1t-1:s2tb] as the sixth transmission data.

Each of the number of bits s1t of the second transmission data and the number of bits s2tb of the fifth transmission data may be stored in an internal memory of the second bit stream output unit 12 or may be supplied from the outside of the information bit stream distribution device 1-3.

The second bit stream output unit 12 of the information bit stream distribution device 1-3 extracts, from the second dummy data included in the invalid bit stream B1t[v1t-1:s1t] of the second information bit stream B1t[v1t-1:0], dummy data other than the fifth transmission data as sixth dummy data.

That is, the second bit stream output unit 12 extracts, from the second dummy data included in the invalid bit stream B1t[v1t-1:s1t], a bit stream of B1t[v1t-1:s1t+(v2tb-s2tb)] as the sixth dummy data.

The number of bits v2tb of the fifth information bit stream B2tb[v2tb-1:0] may be stored in the internal memory of the second bit stream output unit 12 or may be supplied from the outside of the information bit stream distribution device 1-3.

The second bit stream output unit 12 of the information bit stream distribution device 1-3 generates a sixth information bit stream B2tt[v2tt-1:0] in which the sixth transmission data is transmitted at a sixth speed.

That is, the second bit stream output unit 12 generates the sixth information bit stream B2tt[v2tt-1:0] having the valid bit stream B2tt[s2tt-1:0] including the extracted sixth transmission data and the invalid bit stream B2tt[v2tt-1:s2tt] including the extracted sixth dummy data.

The sixth speed at which the sixth transmission data is transmitted is represented by s2tt/v2tt, and the higher a ratio of the number of bits s2tt of the sixth transmission data to the number of bits v2tt of the sixth information bit stream, the higher the sixth speed.

The second bit stream output unit 12 of the information bit stream distribution device 1-3 outputs the sixth information bit stream B2tt[v2tt-1:0] in which the sixth transmission data is transmitted at the sixth speed to the outside.

In the information bit stream distribution device 3 illustrated in FIG. 7, for example, it is assumed that v1b = v1t = w/2 and v2bb = v2bt = v2tb = v2tt = w/4 are satisfied. In this case, the transmission data included in the valid bit stream of the information bit stream Bsrc[w-1:0] can be divided into the third transmission data having the number of bits proportional to a third speed s2bb/(w/4), the fourth transmission data having the number of bits proportional to a fourth speed s2bt/(w/4), the fifth transmission data having the number of bits proportional to a fifth speed s2tb/(w/4), and the sixth transmission data having the number of bits proportional to a sixth speed s2tt/(w/4), and the third transmission data, the fourth transmission data, the fifth transmission data, and the sixth transmission data can be distributed to four respective subcarriers. Note that v1b = v1t = w/2 and v2bb = v2bt = v2tb = v2tt = w/4 do not have to be satisfied, and vb ≠ vt or v2bb ≠ v2bt ≠ v2tb ≠ v2tt may be satisfied.

In the information bit stream distribution device 3 illustrated in FIG. 7, the three information bit stream distribution devices 1-1, 1-2, and 1-3 are arranged in a tree shape, and the number of stages of the information bit stream distribution device 3 is two. However, this is merely an example, and for example, seven information bit stream distribution devices 1 may be arranged in a tree shape, and the number of stages of the information bit stream distribution device 3 may be three. In addition, fifteen information bit stream distribution devices 1 may be arranged in a tree shape, and the number of stages of the information bit stream distribution device 3 may be four.

In the three-stage configuration, the information bit stream distribution device 3 can divide the information bit stream Bsrc[w-1:0] into eight information bit streams, and supply the divided information bit streams to eight respective subcarriers.

In the four-stage configuration, the information bit stream distribution device 3 can divide the information bit stream Bsrc[w-1:0] into 16 information bit streams, and supply the divided information bit streams to 16 respective subcarriers.

The information bit stream distribution device 3 can increase the division number of the information bit stream by a power of 2 by increasing the number of stages.

### Third Example.

In a third embodiment, an information bit stream distribution device 3 including three information bit stream distribution devices 1 illustrated in FIG. 1 will be described.

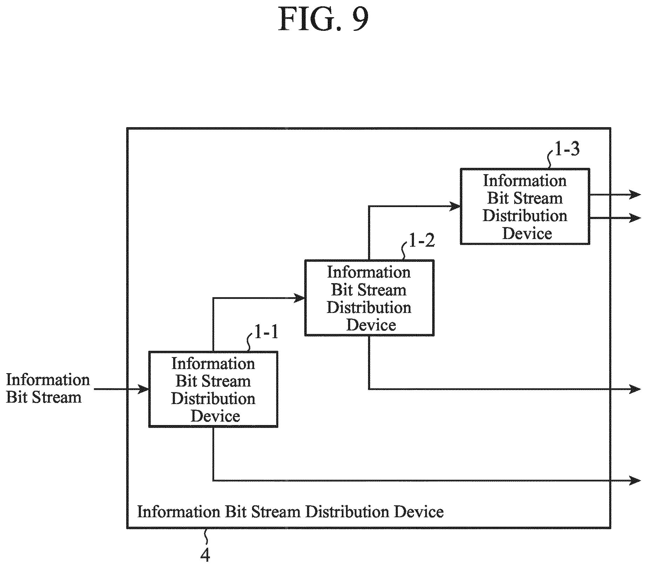

FIG. 9 is a configuration diagram illustrating an information bit stream distribution device 4 according to the third example. In FIG. 9, the same reference numerals as in FIG. 1 indicate the same or corresponding parts, and therefore description thereof is omitted.

The information bit stream distribution device 4 illustrated in FIG. 9 includes information bit stream distribution devices 1-1, 1-2, and 1-3.

Each of the information bit stream distribution devices 1-1, 1-2, and 1-3 is the same information bit stream distribution device as the information bit stream distribution device 1 illustrated in FIG. 1.

Among the three information bit stream distribution devices, the first information bit stream distribution device 1-1 acquires an information bit stream.

The first information bit stream distribution device 1-1 outputs a first information bit stream to the outside, and outputs a second information bit stream to the second information bit stream distribution device 1-2.

The second information bit stream distribution device 1-2 acquires the second information bit stream output from the information bit stream distribution device 1-1.

The information bit stream distribution device 1-2 extracts, from second transmission data included in a valid bit stream of the second information bit stream, some pieces of transmission data as seventh transmission data.

The information bit stream distribution device 1-2 outputs an information bit stream having a valid bit stream including the seventh transmission data and an invalid bit stream including dummy data to the outside as a seventh information bit stream in which the seventh transmission data is transmitted at a seventh speed.

In addition, the information bit stream distribution device 1-2 extracts, from the second transmission data included in the valid bit stream of the second information bit stream, transmission data other than the seventh transmission data as eighth transmission data.

The information bit stream distribution device 1-2 outputs an eighth information bit stream having a valid bit stream including the eighth transmission data and an invalid bit stream including dummy data to the third information bit stream distribution device 1-3.

The third information bit stream distribution device 1-3 acquires the eighth information bit stream output from the information bit stream distribution device 1-2.

The information bit stream distribution device 1-3 extracts, from the eighth transmission data included in the valid bit stream of the eighth information bit stream, some pieces of transmission data as ninth transmission data.

The information bit stream distribution device 1-3 outputs an information bit stream having a valid bit stream including the ninth transmission data and an invalid bit stream including dummy data to the outside as a ninth information bit stream in which the ninth transmission data is transmitted at a ninth speed.

In addition, the information bit stream distribution device 1-3 extracts, from the eighth transmission data included in the valid bit stream of the ninth information bit stream, transmission data other than the ninth transmission data as tenth transmission data.

The information bit stream distribution device 1-3 outputs an information bit stream having a valid bit stream including the tenth transmission data and an invalid bit stream including dummy data to the outside as a tenth information bit stream in which the tenth transmission data is transmitted at a tenth speed.

Next, an operation of the information bit stream distribution device 4 illustrated in FIG. 9 will be described.

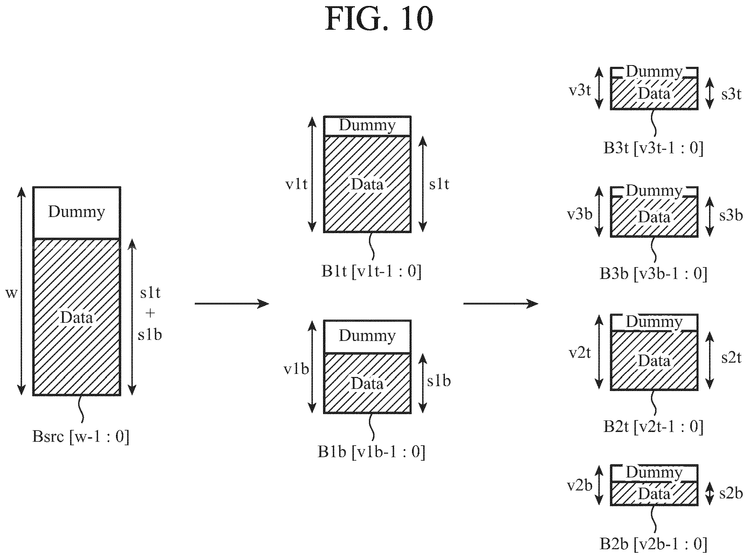

FIG. 10 is an explanatory diagram illustrating examples of the information bit stream, the first information bit stream, the second information bit stream, the seventh information bit stream, the eighth information bit stream, the ninth information bit stream, and the tenth information bit stream.

As illustrated in FIG. 10, the information bit stream distribution device 1-1 acquires an information bit stream Bsrc[w-1:0] from the outside.

Since an operation of the information bit stream distribution device 1-1 is similar to the operation of the information bit stream distribution device 1-1 illustrated in FIG. 7, a detailed description thereof is omitted.

The information bit stream distribution device 1-1 outputs a first information bit stream B1b[v1b-1:0] to the outside, and outputs a second information bit stream B1t[v1t-1:0] to the information bit stream distribution device 1-2.

A first bit stream output unit 11 of the information bit stream distribution device 1-2 acquires the second information bit stream B1t[v1t-1:0] from the information bit stream distribution device 1-1.

The first bit stream output unit 11 of the information bit stream distribution device 1-2 extracts, from second transmission data included in a valid bit stream B1t[s1t-1:0] of the second information bit stream B1t[v1t-1:0], some pieces of transmission data as seventh transmission data. s1t = s2b + s2t is satisfied, and s2b and s2t are non-negative integers.

That is, the first bit stream output unit 11 extracts, from the second transmission data included in the valid bit stream B1t[s1t-1:0], a bit stream of B1t[s2b-1:0] as the seventh transmission data.

The number of bits s2b of the seventh transmission data may be stored in an internal memory of the first bit stream output unit 11 or may be supplied from the outside of the information bit stream distribution device 1-2.

The first bit stream output unit 11 of the information bit stream distribution device 1-2 extracts, from second dummy data included in an invalid bit stream B1t[v1t-1:s1t] of the second information bit stream B1t[v1t-1:0], some pieces of dummy data as seventh dummy data.

That is, the first bit stream output unit 11 extracts, from the second dummy data included in the invalid bit stream B1t[v1t-1:s1t], a bit stream of B1t[s1t+(v2b-s2b)-1:s1t] as the seventh dummy data.

Each of the number of bits s1t of the second transmission data and the number of bits v2b of a seventh information bit stream B2b[v2b-1:0] may be stored in the internal memory of the first bit stream output unit 11 or may be supplied from the outside of the information bit stream distribution device 1-2.

The first bit stream output unit 11 of the information bit stream distribution device 1-2 generates the seventh information bit stream B2b[v2b-1:0] in which the seventh transmission data is transmitted at a seventh speed.

That is, the first bit stream output unit 11 generates the seventh information bit stream B2b[v2b-1:0] having the valid bit stream B2b[s2b-1:0] including the extracted seventh transmission data and the invalid bit stream B2b[v2b-1:s2b] including the extracted seventh dummy data.

The seventh speed at which the seventh transmission data is transmitted is represented by s2b/v2b, and the higher a ratio of the number of bits s2b of the seventh transmission data to the number of bits v2b of the seventh information bit stream, the higher the seventh speed.

The first bit stream output unit 11 of the information bit stream distribution device 1-2 outputs the seventh information bit stream B2b[v2b-1:0] in which the seventh transmission data is transmitted at the seventh speed to the outside.

The first bit stream output unit 11 of the information bit stream distribution device 1-2 outputs the acquired second information bit stream B1t[v1t-1:0] to a second bit stream output unit 12.

The second bit stream output unit 12 of the information bit stream distribution device 1-2 acquires the second information bit stream B1t[v1t-1:0] from the first bit stream output unit 11.

The second bit stream output unit 12 extracts, from the second transmission data included in the valid bit stream B1t[s1t-1:0] of the second information bit stream B1t[v1t-1:0], transmission data other than the seventh transmission data as eighth transmission data.

That is, the first bit stream output unit 11 extracts, from the second transmission data included in the valid bit stream B1t[s1t-1:0], a bit stream of B1t[s1t-1:s2b] as the eighth transmission data.

Each of the number of bits s1t of the second transmission data and the number of bits s2b of the seventh transmission data may be stored in an internal memory of the second bit stream output unit 12 or may be supplied from the outside of the information bit stream distribution device 1-2.

The second bit stream output unit 12 of the information bit stream distribution device 1-2 extracts, from the second dummy data included in the invalid bit stream B1t[v1t-1:s1t] of the second information bit stream B1t[v1t-1:0], dummy data other than the seventh transmission data as eighth dummy data.

That is, the second bit stream output unit 12 extracts, from the second dummy data included in the invalid bit stream B1t[v1t-1:s1t], a bit stream of B1t[v1t-1:s1t+(v2b-s2b)] as the eighth dummy data.

The number of bits v2b of the seventh information bit stream B2b[v2b-1:0] may be stored in the internal memory of the second bit stream output unit 12 or may be supplied from the outside of the information bit stream distribution device 1-2.

The second bit stream output unit 12 of the information bit stream distribution device 1-2 generates an eighth information bit stream B2t[v2t-1:0] in which the eighth transmission data is transmitted at an eighth speed.

That is, the second bit stream output unit 12 generates the eighth information bit stream B2t[v2t-1:0] having the valid bit stream B2t[s2t-1:0] including the extracted eighth transmission data and the invalid bit stream B2t[v2t-1:s2t] including the extracted eighth dummy data.

The second bit stream output unit 12 of the information bit stream distribution device 1-2 outputs the eighth information bit stream B2t[v2t-1:0] to the information bit stream distribution device 1-3.

A first bit stream output unit 11 of the information bit stream distribution device 1-3 acquires the eighth information bit stream B2t[v2t-1:0] from the information bit stream distribution device 1-2.

The first bit stream output unit 11 of the information bit stream distribution device 1-3 extracts, from the eighth transmission data included in the valid bit stream B2t[s2t-1:0] of the eighth information bit stream B2t[v2t-1:0], some pieces of transmission data as ninth transmission data.

That is, the first bit stream output unit 11 extracts, from the eighth transmission data included in the valid bit stream B2t[s2t-1:0], a bit stream of B2t[s3b-1:0]] as the ninth transmission data.

The number of bits s3b of the ninth transmission data may be stored in an internal memory of the first bit stream output unit 11 or may be supplied from the outside of the information bit stream distribution device 1-3.

The first bit stream output unit 11 of the information bit stream distribution device 1-3 extracts, from the eighth dummy data included in the invalid bit stream B2t[v2t-1:s2t] of the eighth information bit stream B2t[v2t-1:0], some pieces of dummy data as ninth dummy data.

That is, the first bit stream output unit 11 extracts, from the eighth dummy data included in the invalid bit stream B2t[v2t-1: s2t], a bit stream of B2t[s2t+(v3b-s3b)-1:s2t] as the ninth dummy data.

Each of the number of bits s2t of the eighth transmission data and the number of bits v3b of the ninth information bit stream B3b[v3b-1:0] may be stored in the internal memory of the first bit stream output unit 11 or may be supplied from the outside of the information bit stream distribution device 1-3.

The first bit stream output unit 11 of the information bit stream distribution device 1-3 generates a ninth information bit stream B3b[v3b-1:0] in which the ninth transmission data is transmitted at a ninth speed.

That is, the first bit stream output unit 11 generates the ninth information bit stream B3b[v3b-1:0] having the valid bit stream B3b[s3b-1:0] including the extracted ninth transmission data and the invalid bit stream B3b[v3b-1:s3b] including the extracted ninth dummy data.

The ninth speed at which the ninth transmission data is transmitted is represented by s3b/v3b, and the higher a ratio of the number of bits s3b of the ninth transmission data to the number of bits v3b of the ninth information bit stream, the higher the ninth speed.

The first bit stream output unit 11 of the information bit stream distribution device 1-3 outputs the ninth information bit stream B3b[v3b-1:0] in which the ninth transmission data is transmitted at the ninth speed to the outside.

The first bit stream output unit 11 of the information bit stream distribution device 1-3 outputs the acquired eighth information bit stream B2t[v2t-1:0] to a second bit stream output unit 12.

The second bit stream output unit 12 of the information bit stream distribution device 1-3 acquires the eighth information bit stream B2t[v2t-1:0] from the first bit stream output unit 11.

The second bit stream output unit 12 extracts, from the eighth transmission data included in the valid bit stream B2t[s2t-1:0] of the eighth information bit stream B2t[v2t-1:0], transmission data other than the ninth transmission data as tenth transmission data.

That is, the first bit stream output unit 11 extracts, from the eighth transmission data included in the valid bit stream B2t[s2t-1:0], a bit stream of B2t[s2t-1:s3b] as the tenth transmission data.

Each of the number of bits s2t of the eighth transmission data and the number of bits s3b of the ninth transmission data may be stored in an internal memory of the second bit stream output unit 12 or may be supplied from the outside of the information bit stream distribution device 1-3.

The second bit stream output unit 12 of the information bit stream distribution device 1-3 extracts, from the eighth dummy data included in the invalid bit stream B2t[v2t-1:s2t] of the eighth information bit stream B2t[v2t-1:0], dummy data other than the ninth transmission data as tenth dummy data.

That is, the second bit stream output unit 12 extracts, from the eighth dummy data included in the invalid bit stream B2t[v2t-1:s2t], a bit stream of B2t[v2t-1:s2t+(v3b-s3b)] as the tenth dummy data.

The number of bits v3b of the ninth information bit stream B3b[v3b-1:0] may be stored in the internal memory of the second bit stream output unit 12 or may be supplied from the outside of the information bit stream distribution device 1-3.

The second bit stream output unit 12 of the information bit stream distribution device 1-3 generates a tenth information bit stream B3t[v3t-1:0] in which the tenth transmission data is transmitted at a tenth speed.

That is, the second bit stream output unit 12 generates the tenth information bit stream B3t[v3t-1:0] having the valid bit stream B3t[s3t-1:0] including the extracted tenth transmission data and the invalid bit stream B3t[v3t-1:s3t] including the extracted tenth dummy data.

The tenth speed at which the tenth transmission data is transmitted is represented by s3t/v3t, and the higher a ratio of the number of bits s3t of the tenth transmission data to the number of bits v3t of the tenth information bit stream, the higher the tenth speed.

The second bit stream output unit 12 of the information bit stream distribution device 1-2 outputs the tenth information bit stream B3t[v3t-1:0] in which the tenth transmission data is transmitted at the tenth speed to the outside.

For example, it is assumed that w0 is a natural number of a multiple of 4, and v1b = w0, v1t = w0, v2b = v2t = w0/2, and v3b = v3t = w0/4 are satisfied. In this case, the information bit stream distribution device 4 illustrated in FIG. 9 can divide the information bit stream Bsrc[w-1:0] in such a manner that a maximum value of a speed after branching satisfies v1b = w0, v2b = w0/2, v3b = w0/4, and v3t = w0/4.

The number of stages of the information bit stream distribution device 4 illustrated in FIG. 9 is three. However, this is merely an example, and for example, four information bit stream distribution devices 1 may be arranged, and the number of stages of the information bit stream distribution device 4 may be four. In addition, five information bit stream distribution devices 1 may be arranged, and the number of stages of the information bit stream distribution device 4 may be five.

### First Embodiment of the invention.

In a first embodiment, an information bit stream conversion circuit 30 including an information bit stream distribution device 3 and information bit stream distribution devices 4-1 to 4-4 will be described.

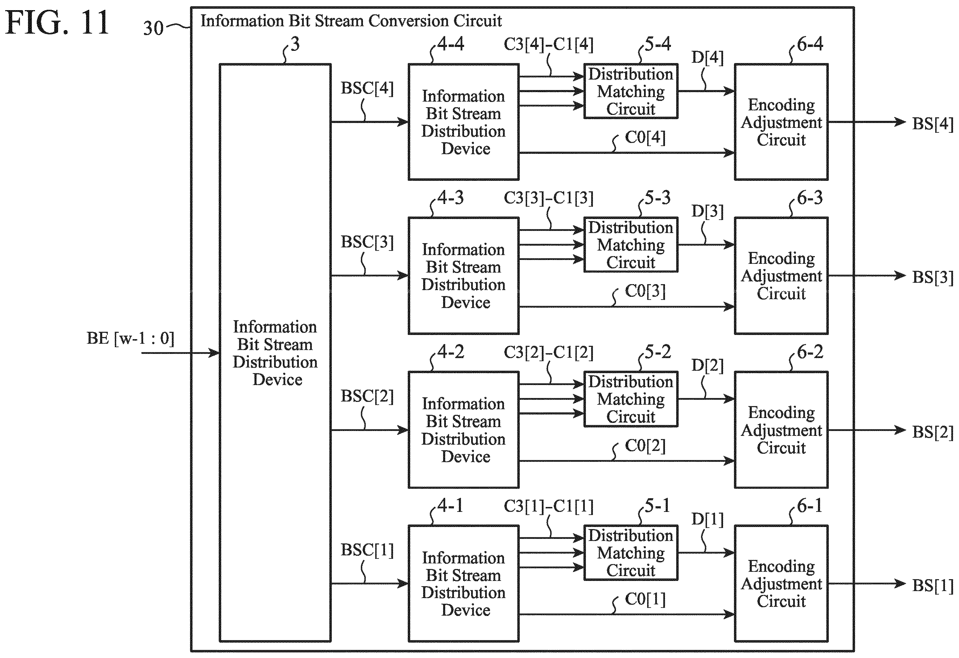

FIG. 11 is a configuration diagram illustrating the information bit stream conversion circuit 30 according to the first embodiment.

The information bit stream conversion circuit 30 illustrated in FIG. 11 includes the information bit stream distribution device 3 illustrated in FIG. 7, the information bit stream distribution devices 4-1 to 4-4, distribution matching circuits 5-1 to 5-4, and encoding adjustment circuits 6-1 to 6-4. Each of the information bit stream distribution devices 4-1 to 4-4 is the same information bit stream distribution device as the information bit stream distribution device 4 illustrated in FIG. 9.

The information bit stream distribution device 3 is a first information bit stream distribution device, and each of the information bit stream distribution devices 4-1 to 4-4 is a second information bit stream distribution device.

The information bit stream conversion circuit 30 illustrated in FIG. 11 includes four second information bit stream distribution devices. However, this is merely an example, and the information bit stream conversion circuit 30 may include five or more second information bit stream distribution devices. When the information bit stream conversion circuit 30 includes five or more second information bit stream distribution devices, the information bit stream conversion circuit 30 includes five or more distribution matching circuits and five or more encoding adjustment circuits.

The information bit stream distribution device 3 acquires an information bit stream BE[w-1:0], outputs a third information bit stream BSC[1] to the information bit stream distribution device 4-1, and outputs a fourth information bit stream BSC[2] to the information bit stream distribution device 4-2.

In addition, the information bit stream distribution device 3 outputs a fifth information bit stream BSC[3] to the information bit stream distribution device 4-3, and outputs a sixth information bit stream BSC[4] to the information bit stream distribution device 4-4.

The third information bit stream BSC[1] corresponds to the third information bit stream B2bb[v2bb-1:0] illustrated in FIG. 8, and the fourth information bit stream BSC[2] corresponds to the fourth information bit stream B2bt[v2bt-1:0] illustrated in FIG. 8.

The fifth information bit stream BSC[3] corresponds to the fifth information bit stream B2tb[v2tb-1:0] illustrated in FIG. 8, and the sixth information bit stream BSC[4] corresponds to the sixth information bit stream B2tt[v2tt-1:0] illustrated in FIG. 8.

The information bit stream distribution device 4-1 acquires the third information bit stream BSC[1] and outputs a first information bit stream C0[1] to an encoding adjustment circuit 6-1.

In addition, the information bit stream distribution device 4-1 outputs each of a seventh information bit stream C1[1], a ninth information bit stream C2[1], and a tenth information bit stream C3[1] to a distribution matching circuit 5-1.

The first information bit stream C0[1] corresponds to the first information bit stream B1b[v1b-1:0] illustrated in FIG. 10, and the seventh information bit stream C1[1] corresponds to the seventh information bit stream B2b[v2b-1:0] illustrated in FIG. 10.

The ninth information bit stream C2[1] corresponds to the ninth information bit stream B3b[v3b-1:0] illustrated in FIG. 10, and the tenth information bit stream C3[1] corresponds to the tenth information bit stream B3t[v3t-1:0] illustrated in FIG. 10.

The information bit stream distribution device 4-2 acquires the fourth information bit stream BSC[2] and outputs a first information bit stream C0[2] to an encoding adjustment circuit 6-2.

In addition, the information bit stream distribution device 4-2 outputs each of a seventh information bit stream C1[2], a ninth information bit stream C2[2], and a tenth information bit stream C3[2] to a distribution matching circuit 5-2.

The first information bit stream C0[2] corresponds to the first information bit stream B1b[v1b-1:0] illustrated in FIG. 10, and the seventh information bit stream C1[2] corresponds to the seventh information bit stream B2b[v2b-1:0] illustrated in FIG. 10.

The ninth information bit stream C2[2] corresponds to the ninth information bit stream B3b[v3b-1:0] illustrated in FIG. 10, and the tenth information bit stream C3[2] corresponds to the tenth information bit stream B3t[v3t-1:0] illustrated in FIG. 10.

The information bit stream distribution device 4-3 acquires the fifth information bit stream BSC[3] and outputs a first information bit stream C0[3] to an encoding adjustment circuit 6-3.

In addition, the information bit stream distribution device 4-3 outputs each of a seventh information bit stream C1[3], a ninth information bit stream C2[3], and a tenth information bit stream C3[3] to a distribution matching circuit 5-3.

The first information bit stream C0[3] corresponds to the first information bit stream B1b[v1b-1:0] illustrated in FIG. 10, and the seventh information bit stream C1[3] corresponds to the seventh information bit stream B2b[v2b-1:0] illustrated in FIG. 10.

The ninth information bit stream C2[3] corresponds to the ninth information bit stream B3b[v3b-1:0] illustrated in FIG. 10, and the tenth information bit stream C3[3] corresponds to the tenth information bit stream B3t[v3t-1:0] illustrated in FIG. 10.

The information bit stream distribution device 4-4 acquires the sixth information bit stream BSC[4] and outputs a first information bit stream C0[4] to an encoding adjustment circuit 6-4.

In addition, the information bit stream distribution device 4-4 outputs each of a seventh information bit stream C1[4], a ninth information bit stream C2[4], and a tenth information bit stream C3[4] to a distribution matching circuit 5-4.

The first information bit stream C0[4] corresponds to the first information bit stream B1b[v1b-1:0] illustrated in FIG. 10, and the seventh information bit stream C1[4] corresponds to the seventh information bit stream B2b[v2b-1:0] illustrated in FIG. 10.

The ninth information bit stream C2[4] corresponds to the ninth information bit stream B3b[v3b-1:0] illustrated in FIG. 10, and the tenth information bit stream C3[4] corresponds to the tenth information bit stream B3t[v3t-1:0] illustrated in FIG. 10.

The distribution matching circuit 5-k (k = 1, 2, 3, or 4) acquires each of the seventh information bit stream C1[k], the ninth information bit stream C2[k], and the tenth information bit stream C3[k] output from the information bit stream distribution device 4-k.

The distribution matching circuit 5-k performs probabilistic shaping of signal point arrangement used for communication on the basis of the seventh information bit stream C1[k], the ninth information bit stream C2[k], and the tenth information bit stream C3[k], and outputs a bit stream D[k] after the probability distribution shaping to the encoding adjustment circuit 6-k.

The distribution matching circuit 5-k is, for example, a circuit similar to the distribution matching circuit disclosed in Patent Literature 1, and a detailed description of the distribution matching circuit 5-k is omitted.

### Patent Literature 1: WO 2020/031257 A

The encoding adjustment circuit 6-k (k = 1, 2, 3, or 4) acquires the first information bit stream CO[k] output from the information bit stream distribution device 4-k and the bit stream D[k] after the probability distribution shaping output from the distribution matching circuit 5-k.

The encoding adjustment circuit 6-k generates a shaping bit stream BS[k] that is a bit stream partially subjected to probability distribution shaping on the basis of the first information bit stream CO[k] and the bit stream D[k] after the probability distribution shaping, and outputs the shaping bit stream BS[k] to the outside.

Here, for convenience of description, it is assumed that the bit stream D[k] after the probability distribution shaping is a bit stream in which an 8-value amplitude shift keying (ASK) symbol that takes any one of eight values of 1, 3, 5, 7, 9, 11, 13, and 15 as an amplitude value is subjected to probability distribution shaping.

Since three bits are required to represent the 8ASK symbol, when an output block of the distribution matching circuit 5-k is constituted by 128 ASK symbols, at least 384 bits are required as the number of bits of the bit stream D[k].

In addition, when the bit stream D[k] after the probability distribution shaping is a 16ASK symbol that takes any one of sixteen values of 1, 3, 5, 7, 9, 11, 13, 15, 17, 19, 21, 23, 25, 27, 29, and 31 as an amplitude value, at least 512 bits are required as the number of bits of the bit stream D[k].

As a multivalued degree of the symbol increases, a larger number of bits is required as the number of bits of the bit stream D[k]. As the number of bits of the bit stream D[k] increases, power consumption of the distribution matching circuit 5-k or the like increases in addition to a circuit scale of the distribution matching circuit 5-k or the like. Therefore, the number of bits of the bit stream D[k] is desirably small.

In order to reduce the number of bits of the bit stream D[k], the encoding adjustment circuit 6-k generate the shaping bit stream BS[k] corresponding to a symbol stream having more values than a symbol stream represented by the bit stream D[k] by combining the bit stream D[k] corresponding to a symbol stream and the first information bit stream CO[k].

The encoding adjustment circuit 6-k outputs the generated shaping bit stream BS[k] to the outside.

For example, it is assumed that the bit stream D[k] is a 3-bit × 128 bit stream representing an 8ASK symbol stream of 128 symbols, and the first information bit stream CO[k] is a 1-bit × 128 bit stream in which 8ASK symbols are expanded.

By combining the 3-bit × 128 bit stream and the 1-bit × 128 bit stream, a 4-bit × 128 bit stream E[k] representing a 16ASK symbol stream of 128 symbols, which has been subjected to probability distribution shaping, is obtained.

Note that the first information bit stream CO[k] can expand 1 of the 8ASK symbol according to the bit stream D[k] to 1 or 3 of the 16ASK symbol, expand 3 of the 8ASK symbol according to the bit stream D[k] to 5 or 7 of the 16ASK symbol, and expand 15 of the 8ASK symbol according to the bit stream D[k] to 29 or 31 of the 16ASK symbol.

For example, it is assumed that the bit stream D[k] is a 3-bit × 128 bit stream representing an 8-value complex ASK symbol stream of 128 symbols, and the first information bit stream CO[k] is a 1-bit × 128 bit stream in which 8ASK symbols are expanded.

By combining the 3-bit × 128 bit stream and the 1-bit × 128 bit stream, a 4-bit × 128 bit stream E[k] representing a 16-value complex ASK symbol of 128 symbols, which has been subjected to probability distribution shaping, is obtained.

Note that any one of (real part, imaginary part) = (1, 1), (3, 1), (5, 1), (5, 3), (5, 5), (7, 1), (7, 3), and (7, 5) can be selected as the 8-value complex ASK symbol. The first information bit stream CO[k] expands (1, 1) of the 8-value complex ASK symbol according to the bit stream D[k] to (1, 1) or (3, 3), expands (3, 1) of the 8-value complex ASK symbol to (3, 1) or (1, 3), and expands (5, 1) of the 8-value complex ASK symbol to (5, 1) or (1, 5). In addition, the first information bit stream CO[k] can expand (5, 3) of the 8-value complex ASK symbol according to the bit stream D[k] to (5, 3) or (3, 5), expand (5, 5) of the 8-value complex ASK symbol to (5, 5) or (7, 7), expand (7, 1) of the 8-value complex ASK symbol to (7, 1) or (1, 7), expand (7, 3) of the 8-value complex ASK symbol to (7, 3) or (3, 7), and expand (7, 5) of the 8-value complex ASK symbol to (7, 5) or (5, 7).

In the information bit stream conversion circuit 30 illustrated in FIG. 11, the encoding adjustment circuit 6-k (k = 1, 2, 3, or 4) generates the shaping bit stream BS[k] on the basis of the bit stream D[k] after the probability distribution shaping output from the distribution matching circuit 5-k, and outputs the shaping bit stream BS[k] to the outside. However, it is not limited thereto. The information bit stream conversion circuit 30 does not have to include the encoding adjustment circuit 6-k (k = 1, 2, 3, or 4), and the distribution matching circuit 5-k (k = 1, 2, 3, and 4) may output the bit stream D[k] after the probability distribution shaping to the outside as BS[k].

The information bit stream conversion circuit 30 illustrated in FIG. 11 can change a transmission speed of transmission data included in an information bit stream carried by each subcarrier.

### Second embodiment of the invention.

In a second embodiment, an information bit stream decoding device 50 including a data extraction unit 51 and a multiplexing unit 52 will be described.

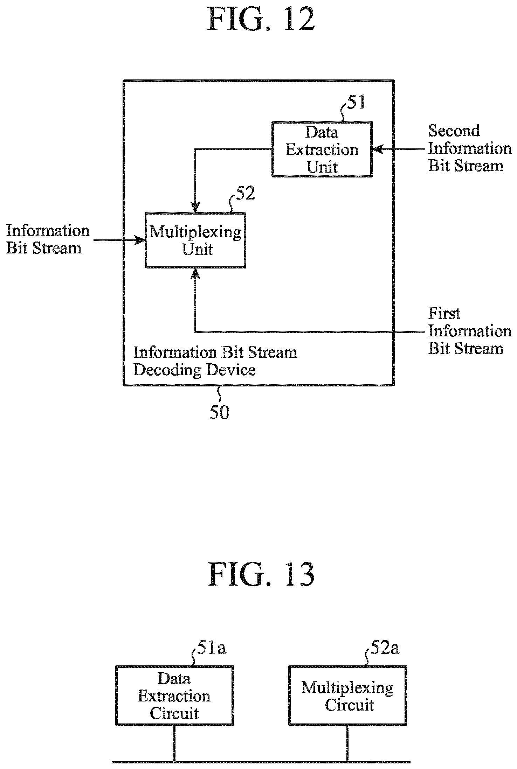

FIG. 12 is a configuration diagram illustrating the information bit stream decoding device 50 according to the second embodiment.

FIG. 13 is a hardware configuration diagram illustrating hardware of the information bit stream decoding device 50 according to the second embodiment.

The information bit stream decoding device 50 illustrated in FIG. 12 includes the data extraction unit 51 and the multiplexing unit 52.

The data extraction unit 51 is implemented by, for example, a data extraction circuit 51a illustrated in FIG. 13.

The data extraction unit 51 extracts second transmission data from a second information bit stream having a valid bit stream including second transmission data and an invalid bit stream including dummy data.

The multiplexing unit 52 is implemented by, for example, a multiplexing circuit 52a illustrated in FIG. 13.

The multiplexing unit 52 extracts first transmission data from a first information bit stream having a valid bit stream including first transmission data and an invalid bit stream including dummy data.

The multiplexing unit 52 generates an information bit stream having a valid bit stream including the extracted first transmission data and the second transmission data extracted by the data extraction unit 51 and an invalid bit stream including dummy data.

In FIG. 12, it is assumed that each of the data extraction unit 51 and the multiplexing unit 52, which are constituent elements of the information bit stream decoding device 50, is implemented by dedicated hardware as illustrated in FIG. 13. That is, it is assumed that the information bit stream decoding device 50 is implemented by the data extraction circuit 51a and the multiplexing circuit 52a.

To each of the data extraction circuit 51a and the multiplexing circuit 52a, for example, a single circuit, a composite circuit, a programmed processor, a parallel programmed processor, an ASIC, an FPGA, or a combination thereof corresponds.

The constituent elements of the information bit stream decoding device 50 are not limited to those implemented by dedicated hardware, and the information bit stream decoding device 50 may be implemented by software, firmware, or a combination of software and firmware.

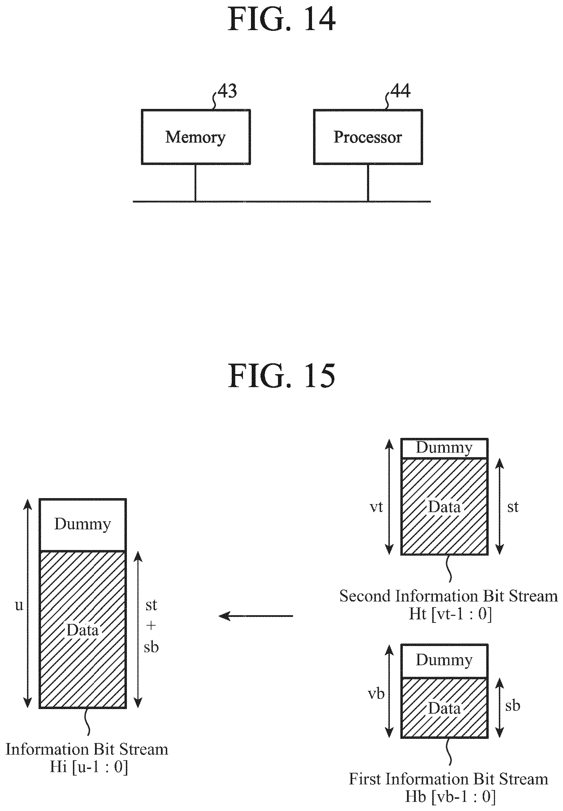

FIG. 14 is a hardware configuration diagram of a computer when the information bit stream decoding device 50 is implemented by software, firmware, or the like.

When the information bit stream decoding device 50 is implemented by software, firmware, or the like, a program for causing a computer to execute processing procedures in each of the data extraction unit 51 and the multiplexing unit 52 is stored in a memory 43. A processor 44 of the computer executes the program stored in the memory 43.

FIG. 13 illustrates an example in which each of the constituent elements of the information bit stream decoding device 50 is implemented by dedicated hardware, and FIG. 14 illustrates an example in which the information bit stream decoding device 50 is implemented by software, firmware, or the like. However, this is merely an example, and some constituent elements in the information bit stream decoding device 50 may be implemented by dedicated hardware, and the remaining constituent elements may be implemented by software, firmware, or the like.

Next, an operation of the information bit stream decoding device 50 illustrated in FIG. 12 will be described.

FIG. 15 is an explanatory diagram illustrating examples of the information bit stream, the first information bit stream, and the second information bit stream.

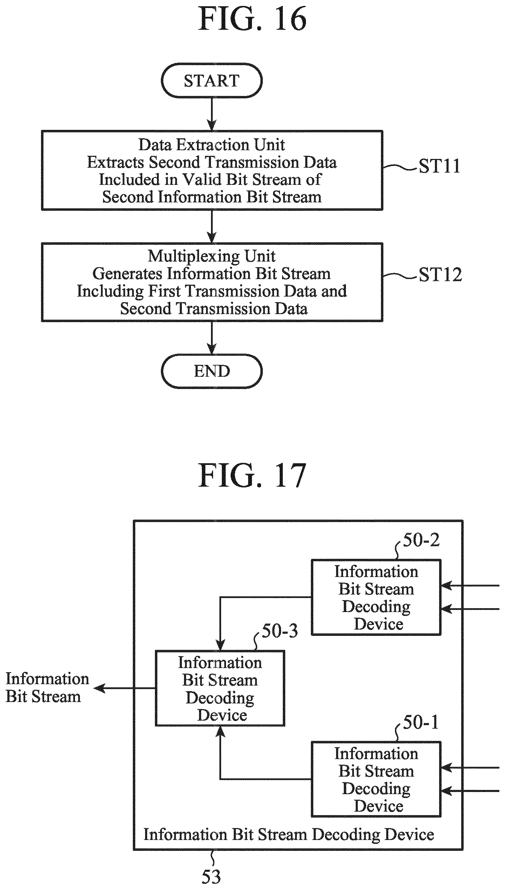

FIG. 16 is a flowchart illustrating an information bit stream decoding method which is a processing procedure performed in the information bit stream decoding device 50.

A second information bit stream Ht[vb-1:0] illustrated in FIG. 15 is supplied to the data extraction unit 51. The second information bit stream Ht[vb-1:0] has a valid bit stream Ht[st-1:0] including the second transmission data and an invalid bit stream Ht[vt-1:st] including second dummy data.

The second information bit stream Ht[vb-1:0] corresponds to the second information bit stream Bt[vb-1:0] illustrated in FIG. 4.

A first information bit stream Hb[vb-1:0] illustrated in FIG. 15 is supplied to the multiplexing unit 52. The first information bit stream Hb[vb-1:0] has a valid bit stream Hb[sb-1:0] including the first transmission data and an invalid bit stream Hb[vb-1:sb] including first dummy data.

The first information bit stream Hb[vb-1:0] corresponds to the first information bit stream Bb[vb-1:0] illustrated in FIG. 4.

When the second information bit stream Ht[vb-1:0] is supplied to the data extraction unit 51, the data extraction unit 51 extracts the second transmission data included in the valid bit stream Ht[st-1:0] of the second information bit stream Ht[vb-1:0] (step ST11 in FIG. 16).

In addition, the data extraction unit 51 extracts the second dummy data included in the invalid bit stream Ht[vt-1:st] of the second information bit stream Ht[vb-1:0].

The data extraction unit 51 outputs each of the second transmission data and the second dummy data to the multiplexing unit 52.

The multiplexing unit 52 acquires each of the second transmission data and the second dummy data from the data extraction unit 51.

When the first information bit stream Hb[vb-1:0] is supplied to the multiplexing unit 52, the multiplexing unit 52 extracts the first transmission data included in the valid bit stream Hb[sb-1:0] of the first information bit stream Hb[vb-1:0].

In addition, the multiplexing unit 52 extracts the first dummy data included in the invalid bit stream Hb[vb-1:sb] of the first information bit stream Hb[vb-1:0].

The multiplexing unit 52 generates an information bit stream Hi[u-1:0] including a valid bit stream Hi[sb+st-1:0] including the first transmission data and the second transmission data and an invalid bit stream Hi[u-1:sb+st] including the first dummy data and the second dummy data (step ST12 in FIG. 16).

The information bit stream decoding device 50 illustrated in FIG. 12 can decode the information bit stream Hi[u-1:0] corresponding to the information bit stream Bi[u-1:0] illustrated in FIG. 4.

### Third embodiment of the invention.

In a third embodiment, an information bit stream decoding device 53 including three information bit stream decoding devices 50 illustrated in FIG. 12 will be described.

FIG. 17 is a configuration diagram illustrating the information bit stream decoding device 53 according to the third embodiment.

The information bit stream decoding device 53 illustrated in FIG. 17 includes information bit stream decoding devices 50-1, 50-2, and 50-3.

Each of the information bit stream decoding devices 50-1, 50-2, and 50-3 is the same information bit stream decoding device as the information bit stream decoding device 50 illustrated in FIG. 12.

Among the three information bit stream decoding devices 50, the first information bit stream decoding device 50-1 acquires the third information bit stream B2bb[v2bb-1:0] illustrated in FIG. 8 and the fourth information bit stream B2bt[v2bt-1:0] illustrated in FIG. 8, and outputs the first information bit stream B1b[v1b-1:0] illustrated in FIG. 8 to the third information bit stream decoding device 50-3.

The third information bit stream B2bb[v2bb-1:0] corresponds to the first information bit stream Hb[vb-1:0] illustrated in FIG. 15, and the fourth information bit stream B2bt[v2bt-1:0] corresponds to the second information bit stream Ht[vb-1:0] illustrated in FIG. 15.

The first information bit stream B1b[v1b-1:0] corresponds to the information bit stream Hi[u-1:0] illustrated in FIG. 15.

Among the three information bit stream decoding devices 50, the second information bit stream decoding device 50-2 acquires the fifth information bit stream B2tb[v2tb-1:0] illustrated in FIG. 8 and the sixth information bit stream B2tt[v2tt-1:0] illustrated in FIG. 8, and outputs the second information bit stream B1t[v1t-1:0] illustrated in FIG. 8 to the third information bit stream decoding device 50-3.

The fifth information bit stream B2tb[v2tb-1:0] corresponds to the first information bit stream Hb[vb-1:0] illustrated in FIG. 15, and the sixth information bit stream B2tt[v2tt-1:0] corresponds to the second information bit stream Ht[vb-1:0] illustrated in FIG. 15.

The second information bit stream B1t[v1t-1:0] corresponds to the information bit stream Hi[u-1:0] illustrated in FIG. 15.

Among the three information bit stream decoding devices 50, the third information bit stream decoding device 50-3 acquires the first information bit stream B1b[v1b-1:0] illustrated in FIG. 8 and the second information bit stream B1t[v1t-1:0] illustrated in FIG. 8, and outputs the information bit stream Bsrc[w-1:0] illustrated in FIG. 8 to the outside.

The information bit stream Bsrc[w-1:0] corresponds to the information bit stream Hi[u-1:0] illustrated in FIG. 15.

The information bit stream decoding device 53 illustrated in FIG. 17 is a device to be paired with the information bit stream distribution device 3 illustrated in FIG. 7, and an operation of the information bit stream decoding device 53 illustrated in FIG. 17 is opposite to an operation of the information bit stream distribution device 3 illustrated in FIG. 7 in input and output.

In the information bit stream decoding device 53 illustrated in FIG. 17, the three information bit stream decoding devices 50-1, 50-2, and 50-3 are arranged in a tree shape, and the number of stages of the information bit stream decoding device 53 is two. However, this is merely an example, and for example, seven information bit stream decoding devices 50 may be arranged in a tree shape, and the number of stages of the information bit stream decoding device 53 may be three. In addition, fifteen information bit stream decoding devices 50 may be arranged in a tree shape, and the number of stages of the information bit stream decoding device 53 may be four.

### Fourth embodiment of the invention.

In a fourth embodiment, an information bit stream decoding device 54 including three information bit stream decoding devices 50 illustrated in FIG. 12 will be described.

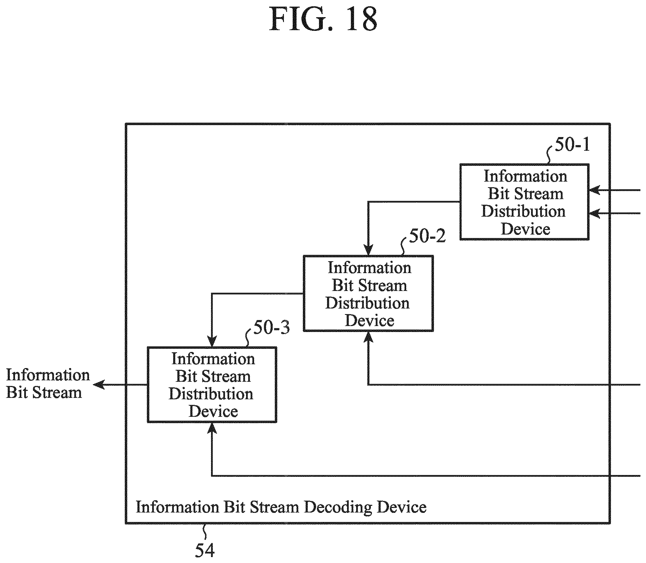

FIG. 18 is a configuration diagram illustrating the information bit stream decoding device 54 according to the fourth embodiment.

The information bit stream decoding device 54 illustrated in FIG. 18 includes information bit stream decoding devices 50-1, 50-2, and 50-3.

Each of the information bit stream decoding devices 50-1, 50-2, and 50-3 is the same information bit stream decoding device as the information bit stream decoding device 50 illustrated in FIG. 12.

Among the three information bit stream decoding devices 50, the first information bit stream decoding device 50-1 acquires the ninth information bit stream B3b[v3b-1:0] illustrated in FIG. 10 and the tenth information bit stream B3t[v3t-1:0] illustrated in FIG. 10, and outputs the eighth information bit stream B2t[v2t-1:0] illustrated in FIG. 10 to the second information bit stream decoding device 50-2.

The ninth information bit stream B3b[v3b-1:0] corresponds to the first information bit stream Hb[vb-1:0] illustrated in FIG. 15, and the tenth information bit stream B3t[v3t-1:0] corresponds to the second information bit stream Ht[vb-1:0] illustrated in FIG. 15.

The eighth information bit stream B2t[v2t-1:0] corresponds to the information bit stream Hi[u-1:0] illustrated in FIG. 15.

Among the three information bit stream decoding devices 50, the second information bit stream decoding device 50-2 acquires the seventh information bit stream B2b[v2b-1:0] illustrated in FIG. 10 and the eighth information bit stream B2t[v2t-1:0] illustrated in FIG. 10, and outputs the second information bit stream B1t[v1t-1:0] illustrated in FIG. 10 to the third information bit stream decoding device 50-3.

The seventh information bit stream B2b[v2b-1:0] corresponds to the first information bit stream Hb[vb-1:0] illustrated in FIG. 15, and the eighth information bit stream B2t[v2t-1:0] corresponds to the second information bit stream Ht[vb-1:0] illustrated in FIG. 15.

The second information bit stream B1t[v1t-1:0] corresponds to the information bit stream Hi[u-1:0] illustrated in FIG. 15.

Among the three information bit stream decoding devices 50, the third information bit stream decoding device 50-3 acquires the first information bit stream B1b[v1b-1:0] illustrated in FIG. 10 and the second information bit stream B1t[v1t-1:0] illustrated in FIG. 10, and outputs the information bit stream Bsrc[w-1:0] illustrated in FIG. 10 to the outside.

The information bit stream Bsrc[w-1:0] corresponds to the information bit stream Hi[u-1:0] illustrated in FIG. 15.

The information bit stream decoding device 54 illustrated in FIG. 18 is a device to be paired with the information bit stream distribution device 4 illustrated in FIG. 9, and an operation of the information bit stream decoding device 54 illustrated in FIG. 18 is opposite to an operation of the information bit stream distribution device 4 illustrated in FIG. 9 in input and output.

The number of stages of the information bit stream decoding device 54 illustrated in FIG. 18 is three. However, this is merely an example, and for example, four information bit stream decoding devices 50 may be arranged, and the number of stages of the information bit stream decoding device 54 may be four. In addition, five information bit stream decoding devices 50 may be arranged, and the number of stages of the information bit stream decoding device 54 may be five.

### Fifth embodiment of the invention.

In an fifth embodiment, an information bit stream inverse conversion circuit 60 including an information bit stream decoding device 53 and information bit stream decoding devices 54-1 to 54-4 will be described.

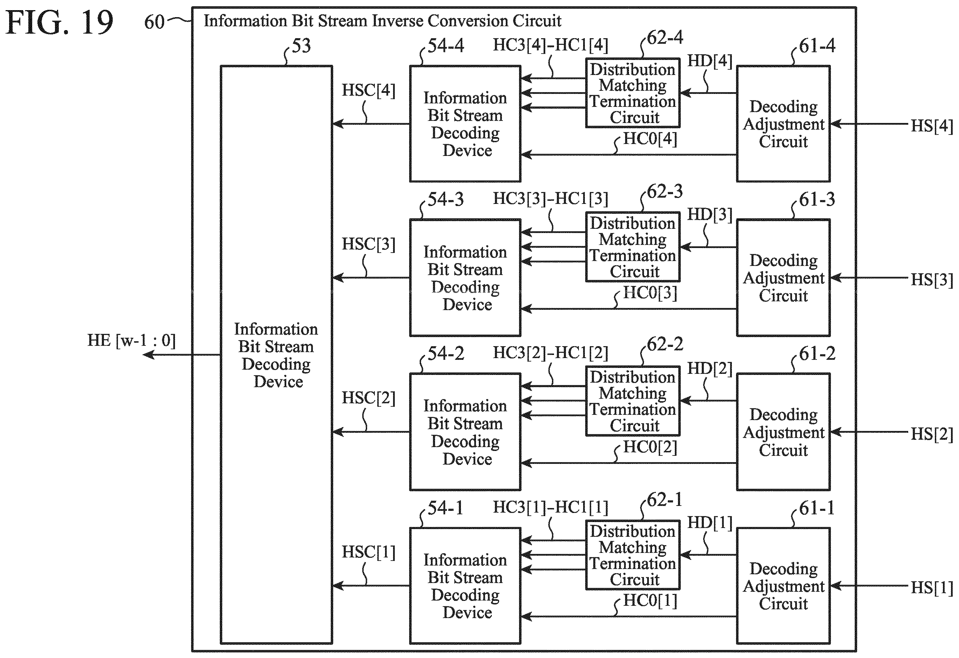

FIG. 19 is a configuration diagram illustrating the information bit stream inverse conversion circuit 60 according to the fifth embodiment.

The information bit stream inverse conversion circuit 60 illustrated in FIG. 19 includes the information bit stream decoding device 53 illustrated in FIG. 17, the information bit stream decoding devices 54-1 to 54-4, decoding adjustment circuits 61-1 to 61-4, and distribution matching termination circuits 62-1 to 62-4. Each of the information bit stream decoding devices 54-1 to 54-4 is the same information bit stream decoding device as the information bit stream decoding device 54 illustrated in FIG. 18.

The information bit stream decoding device 53 is a first information bit stream decoding device, and each of the information bit stream decoding devices 54-1 to 4-54 is a second information bit stream decoding device.

The information bit stream inverse conversion circuit 60 illustrated in FIG. 19 includes four second information bit stream decoding devices. However, this is merely an example, and the information bit stream inverse conversion circuit 60 may include five or more second information bit stream decoding devices. When the information bit stream inverse conversion circuit 60 includes five or more second information bit stream decoding devices, the information bit stream inverse conversion circuit 60 includes five or more decoding adjustment circuits and five or more distribution matching termination circuits.

The decoding adjustment circuit 61-k (k = 1, 2, 3, or 4) is a circuit to be paired with the encoding adjustment circuit 6-k illustrated in FIG. 11, and an operation of the decoding adjustment circuit 61-k is opposite to an operation of the encoding adjustment circuit 6-k in input and output.

A bit stream HS[k] supplied from the outside to the decoding adjustment circuit 61-k corresponds to the shaping bit stream BS[k] output from the encoding adjustment circuit 6-k to the outside.

A bit stream HD[k] output from the decoding adjustment circuit 61-k to the distribution matching termination circuit 62-k corresponds to the bit stream D[k] output from the distribution matching circuit 5-k to the encoding adjustment circuit 6-k.

The distribution matching termination circuit 62-k (k = 1, 2, 3, or 4) is a circuit to be paired with the distribution matching circuit 5-k illustrated in FIG. 11, and an operation of the distribution matching termination circuit 62-k is opposite to an operation of the distribution matching circuit 5-k in input and output.

A seventh information bit stream HC1[k], a ninth information bit stream HC2[k], and a tenth information bit stream HC3[k] output from the distribution matching termination circuit 62-k to the information bit stream decoding device 54-k correspond to the seventh information bit stream C1[k], the ninth information bit stream C2[k], and the tenth information bit stream C3[k] output from the information bit stream distribution device 4-k to the distribution matching circuit 5-k, respectively.

A first information bit stream HC0[k] output from the decoding adjustment circuit 61-k to the information bit stream decoding device 54-k corresponds to the first information bit stream CO[k] output from the information bit stream distribution device 4-k to the encoding adjustment circuit 6-k.

The information bit stream decoding device 54-k (k = 1, 2, 3, or 4) is a circuit to be paired with the information bit stream distribution device 4-k illustrated in FIG. 11, and an operation of the information bit stream decoding device 54-k is opposite to an operation of the information bit stream distribution device 4-k in input and output.

The information bit stream decoding device 54-1 generates a third information bit stream HSC[1] from a first information bit stream HC0[1], a seventh information bit stream HC1[1], a ninth information bit stream HC2[1], and a tenth information bit stream HC3[1].

The information bit stream decoding device 54-2 generates a fourth information bit stream HSC[2] from a first information bit stream HC0[2], a seventh information bit stream HC1[2], a ninth information bit stream HC2[2], and a tenth information bit stream HC3[2].

The information bit stream decoding device 54-3 generates a fifth information bit stream HSC[3] from a first information bit stream HC0[3], a seventh information bit stream HC1[3], a ninth information bit stream HC2[3], and a tenth information bit stream HC3[3].

The information bit stream decoding device 54-4 generates a sixth information bit stream HSC[4] from a first information bit stream HC0[4], a seventh information bit stream HC1[4], a ninth information bit stream HC2[4], and a tenth information bit stream HC3[4].

The third information bit stream HSC[1] corresponds to the third information bit stream BSC[1] output from the information bit stream distribution device 3 to the information bit stream distribution device 4-1, and the fourth information bit stream HSC[2] corresponds to the fourth information bit stream BSC[2] output from the information bit stream distribution device 3 to the information bit stream distribution device 4-2.

The fifth information bit stream HSC[3] corresponds to the fifth information bit stream BSC[3] output from the information bit stream distribution device 3 to the information bit stream distribution device 4-3, and the sixth information bit stream HSC[4] corresponds to the sixth information bit stream BSC[4] output from the information bit stream distribution device 3 to the information bit stream distribution device 4-4.

The information bit stream decoding device 53 is a circuit to be paired with the information bit stream distribution device 3 illustrated in FIG. 11, and an operation of the information bit stream decoding device 53 is opposite to an operation of the information bit stream distribution device 3 in input and output.

An information bit stream HE[w-1:0] output from the information bit stream decoding device 53 to the outside corresponds to the information bit stream BE[w-1:0] supplied from the outside to the information bit stream distribution device 3.

The information bit stream inverse conversion circuit 60 illustrated in FIG. 19 is a device to be paired with the information bit stream conversion circuit 30 illustrated in FIG. 11, and an operation of the information bit stream inverse conversion circuit 60 illustrated in FIG. 19 is opposite to an operation of the information bit stream conversion circuit 30 illustrated in FIG. 11 in input and output.

### Sixth embodiment.

In a ninth embodiment, an optical communication system in which an optical transmitter 70 including the information bit stream conversion circuit 30 illustrated in FIG. 11 and an optical receiver 90 including the information bit stream inverse conversion circuit 60 illustrated in FIG. 19 are connected to each other via an optical transmission line 80 will be described.

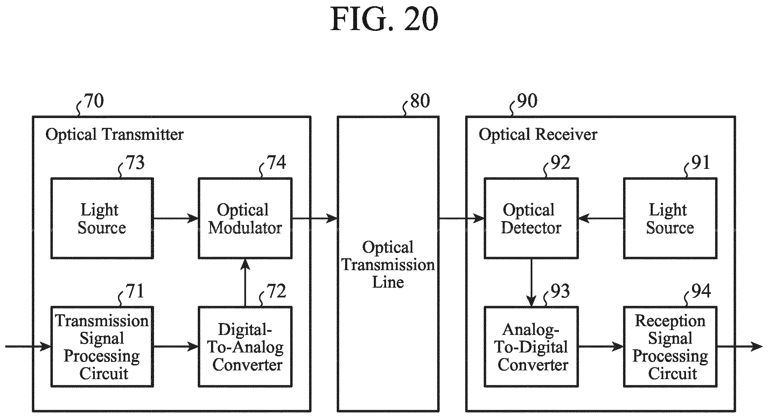

FIG. 20 is a configuration diagram illustrating the optical communication system according to the sixth embodiment.

The optical communication system illustrated in FIG. 20 includes the optical transmitter 70, the optical transmission line 80, and the optical receiver 90.

The optical transmitter 70 includes a transmission signal processing circuit 71, a digital-to-analog converter 72, a light source 73, and an optical modulator 74.

The optical receiver 90 includes a light source 91, an optical detector 92, an analog-to-digital converter 93, and a reception signal processing circuit 94.

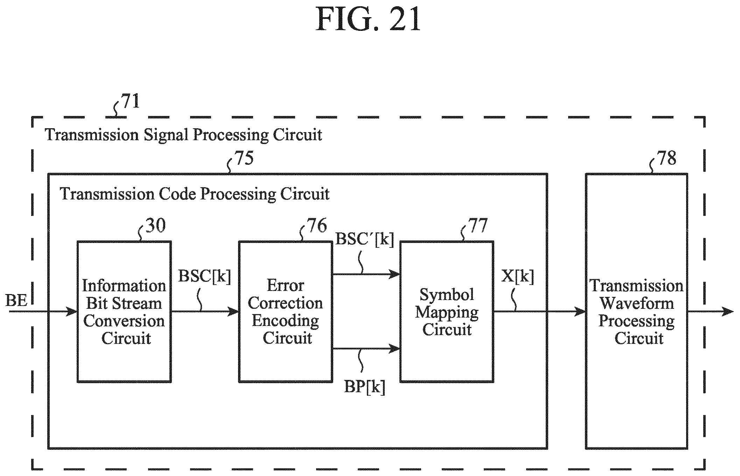

As illustrated in FIG. 21, the transmission signal processing circuit 71 includes a transmission code processing circuit 75 and a transmission waveform processing circuit 78.

FIG. 21 is a configuration diagram illustrating the inside of the transmission signal processing circuit 71.

The transmission code processing circuit 75 includes the information bit stream conversion circuit 30 illustrated in FIG. 11, an error correction encoding circuit 76, and a symbol mapping circuit 77.

The information bit stream conversion circuit 30 acquires an information bit stream BE[w-1:0] from the outside, and outputs each of a third information bit stream BSC[1], a fourth information bit stream BSC[2], a fifth information bit stream BSC[3], and a sixth information bit stream BSC[4] to the error correction encoding circuit 76.

The error correction encoding circuit 76 performs error correction encoding processing on each of the third information bit stream BSC[1], the fourth information bit stream BSC[2], the fifth information bit stream BSC[3], and the sixth information bit stream BSC[4]. Since the error correction encoding processing itself is a known technique, a detailed description thereof is omitted.

The error correction encoding circuit 76 outputs a third information bit stream BSC'[1] after the error correction encoding, a fourth information bit stream BSC'[2] after the error correction encoding, a fifth information bit stream BSC'[3] after the error correction encoding, and a sixth information bit stream BSC'[4] after the error correction encoding to the symbol mapping circuit 77.

In addition, the error correction encoding circuit 76 outputs a parity bit stream BP[k] (k = 1, 2, 3, or 4) generated at the time of the error correction encoding processing to the symbol mapping circuit 77.

The symbol mapping circuit 77 generates a transmission modulation symbol stream X[k] to be transmitted using each of four subcarriers on the basis of the third information bit stream BSC'[1] after the error correction encoding, the fourth information bit stream BSC'[2] after the error correction encoding, the fifth information bit stream BSC' [3] after the error correction encoding, the sixth information bit stream BSC'[4] after the error correction encoding, and the parity bit stream BP[k] (k = 1, 2, 3, or 4). Since the processing itself of generating the transmission modulation symbol stream X[k] by the symbol mapping circuit 77 is a known technique, a detailed description thereof is omitted.

The symbol mapping circuit 77 outputs the transmission modulation symbol stream X[k] to the transmission waveform processing circuit 78.

The transmission waveform processing circuit 78 generates a digital baseband signal by multiplexing the transmission modulation symbol streams X[1] to X[4] output from the symbol mapping circuit 77. Since the processing itself of generating the digital baseband signal by the transmission waveform processing circuit 78 is a known technique, a detailed description thereof is omitted.

The transmission waveform processing circuit 78 outputs the digital baseband signal to the digital-to-analog converter 72.

The digital-to-analog converter 72 converts the digital baseband signal output from the transmission waveform processing circuit 78 into an analog electric signal, and outputs the analog electric signal to the optical modulator 74. The analog electric signal has a baud rate of, for example, several Gbaud to several hundred Gbaud.

The light source 73 is implemented by, for example, an external resonator type wavelength-variable light source.

The light source 73 generates, for example, unmodulated light having a center wavelength of around 1550 nm, and outputs the unmodulated light to the optical modulator 74.

The optical modulator 74 is implemented by, for example, a polarization multiplexing quadrature phase modulator.

The optical modulator 74 generate a transmission optical signal by modulating the unmodulated light output from the light source 73 with the analog electric signal output from the digital-to-analog converter 72.

The optical modulator 74 outputs the transmission optical signal to the optical receiver 90 via the optical transmission line 80.

The optical transmission line 80 is implemented by, for example, an optical fiber, an optical amplifier, an optical multiplexer or demultiplexer, or a wavelength selection switch.

The light source 91 is implemented by, for example, an external resonator type wavelength-variable light source.

The light source 91 generates, for example, unmodulated light having a center wavelength of around 1550 nm, and outputs the unmodulated light to the optical detector 92.

The optical detector 92 receives the transmission optical signal output from the optical modulator 74 as a reception optical signal.

The optical detector 92 generates an analog electric signal by mixing the reception optical signal and the unmodulated light output from the light source 91, and outputs the analog electric signal to the analog-to-digital converter 93.

The analog-to-digital converter 93 converts the analog electric signal output from the optical detector 92 into a digital baseband signal, and outputs the digital baseband signal to the reception signal processing circuit 94.

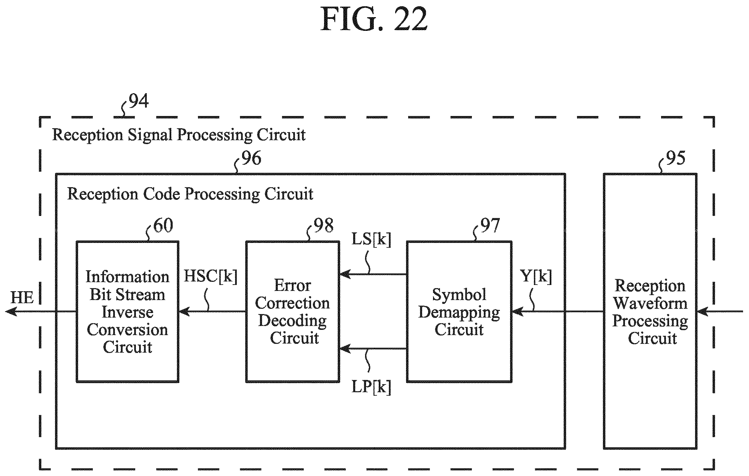

As illustrated in FIG. 22, the reception signal processing circuit 94 includes a reception waveform processing circuit 95 and a reception code processing circuit 96.

FIG. 22 is a configuration diagram illustrating the inside of the reception signal processing circuit 94.

The reception waveform processing circuit 95 separates the digital baseband signal output from the analog-to-digital converter 93 into signals for subcarriers, and generates reception modulation symbol streams Y[1] to Y[4] corresponding to the transmission modulation symbol streams X[1] to X[4], respectively. Since the processing itself of generating the reception modulation symbol stream Y[k] by the reception waveform processing circuit 95 is a known technique, a detailed description thereof is omitted.

The reception waveform processing circuit 95 outputs the reception modulation symbol stream Y[k] to the reception code processing circuit 96.

The reception code processing circuit 96 includes a symbol demapping circuit 97, an error correction decoding circuit 98, and the information bit stream inverse conversion circuit 60 illustrated in FIG. 19.

An operation of the reception code processing circuit 96 is opposite to an operation of the transmission code processing circuit 75 illustrated in FIG. 21 in input and output.

From the reception modulation symbol stream Y[k], the symbol demapping circuit 97 generates an information bit stream LS(k) (k = 1, 2, 3, or 4) corresponding to each of the third information bit stream BSC'[1] after the error correction encoding, the fourth information bit stream BSC'[2] after the error correction encoding, the fifth information bit stream BSC'[3] after the error correction encoding, and the sixth information bit stream BSC'[4] after the error correction encoding.

In addition, the symbol demapping circuit 97 generates a bit stream LP[k] corresponding to the parity bit stream BP[k] (k = 1, 2, 3, or 4).

The symbol demapping circuit 97 outputs each of the information bit stream LS(k) and the bit stream LP[k] to the error correction decoding circuit 98.

The error correction decoding circuit 98 acquires each of the information bit stream LS(k) and the bit stream LP[k] from the symbol demapping circuit 97.

From the information bit stream LS(k) and the bit stream LP[k], the error correction decoding circuit 98 generates an information bit stream HSC[k] (k = 1, 2, 3, or 4) corresponding to each of the third information bit stream BSC[1], the fourth information bit stream BSC[2], the fifth information bit stream BSC[3], and the sixth information bit stream BSC[4].

The error correction decoding circuit 98 outputs the information bit stream HSC[k] to the information bit stream inverse conversion circuit 60.

The information bit stream inverse conversion circuit 60 acquires the information bit stream HSC[k] from the error correction decoding circuit 98.

The optical communication system illustrated in FIG. 20 can change each of a transmission speed and a probability distribution of transmission data for each subcarrier. Therefore, the optical communication system can adjust a trade-off between a data transmission distance or data communication quality and frequency utilization efficiency.

Note that the present disclosure can freely combine the embodiments to each other, modify any constituent element in each of the embodiments, or omit any constituent element in each of the embodiments. The invention is defined by the claims.

### INDUSTRIAL APPLICABILITY

The present disclosure is suitable for an information bit stream distribution device, an information bit stream conversion circuit, an information bit stream distribution method, an information bit stream decoding device, an information bit stream inverse conversion circuit, and an optical communication system.

### REFERENCE SIGNS LIST

1, 1-1, 1-2, 1-3: information bit stream distribution device, 3, 4: information bit stream distribution device, 5-1 to 5-4: distribution matching circuit, 6-1 to 6-4: encoding adjustment circuit, 11: first bit stream output unit, 11a: first bit stream output circuit, 12: second bit stream output unit, 12a: second bit stream output circuit, 21-1, 21-2, 21-3: branching unit, 22: four-lane shifter, 23: two-lane shifter, 24: one-lane shifter, 25-1, 25-2, 25-3: selector, 30: information bit stream conversion circuit, 41, 43: memory, 42, 44: processor, 51: data extraction unit, 51a: data extraction circuit, 52: multiplexing unit, 52a: multiplexing circuit, 50, 50-1, 50-2, 50-3: information bit stream decoding device, 53, 54, 54-1, 54-2, 54-3: information bit stream decoding device, 60: information bit stream inverse conversion circuit, 61-1 to 61-4: decoding adjustment circuit, 62-1 to 62-4: distribution matching termination circuit, 70: optical transmitter, 71: transmission signal processing circuit, 72: digital-to-analog converter, 73: light source, 74: optical modulator, 75: transmission code processing circuit, 76: error correction encoding circuit, 77: symbol mapping circuit, 78: transmission waveform processing circuit, 80: optical transmission line, 90: optical receiver, 91: light source, 92: optical detector, 93: analog-to-digital converter, 94: reception signal processing circuit, 95: reception waveform processing circuit, 96: reception code processing circuit, 97: symbol demapping circuit, 98: error correction decoding circuit.

## Claims

1. An information bit stream conversion circuit (30) in an optical communication system comprising:
one information bit stream distribution device (3) as a primary information bit stream distribution device; and
at least four information bit stream distribution devices (4) as secondary information bit stream distribution devices, wherein
the primary information bit stream distribution device comprises three information bit stream distribution devices (1-1, 1-2, 1-3) being first, second, and third information bit stream distribution devices, and
each of secondary information bit stream distribution devices comprises three information bit stream distribution devices (1-1, 1-2, 1-3), being first, second, and third information bit stream distribution devices,
wherein each of the first, second and third information bit stream distribution devices (1-1, 1-2, 1-3) comprises:
a first bit stream output unit (11) to acquire an information bit stream having a valid bit stream including transmission data and an invalid bit stream including dummy data, to extract, from the transmission data included in the valid bit stream of the information bit stream acquired by the first bit stream output unit (11), transmission data whose number of bits is represented by sb as first transmission data, and to output, as a first information bit stream in which the first transmission data is transmitted at a first speed, an information bit stream having a valid bit stream including the first transmission data and an invalid bit stream including dummy data; and
a second bit stream output unit (12) to extract, from the transmission data included in the valid bit stream of the information bit stream acquired by the first bit stream output unit (11), transmission data, whose number of bits is represented by st, other than the first transmission data as second transmission data, and to output, as a second information bit stream in which the second transmission data is transmitted at a second speed, an information bit stream having a valid bit stream including the second transmission data and an invalid bit stream including dummy data,
wherein the number sb is determined according to the first speed at which the first transmission data is transmitted,
the number st is determined according to the second speed at which the second transmission data is transmitted,
the number sb increases as the first speed increases, and
the number st increases as the second speed increases, and
wherein in the primary information bit stream distribution device,
the first information bit stream distribution device (1-1) acquires the information bit stream having a valid bit stream including transmission data and an invalid bit stream including dummy data, outputs the first information bit stream to the second information bit stream distribution device, and outputs the second information bit stream to the third information bit stream distribution device,
the second information bit stream distribution device (1-2) extracts, from the first transmission data included in the valid bit stream of the first information bit stream, some pieces of transmission data as third transmission data, outputs an information bit stream having a valid bit stream including the third transmission data and an invalid bit stream including dummy data as a third information bit stream in which the third transmission data is transmitted at a third speed, extracts, from the first transmission data, transmission data other than the third transmission data as fourth transmission data, and outputs an information bit stream having a valid bit stream including the fourth transmission data and an invalid bit stream including dummy data as a fourth information bit stream in which the fourth transmission data is transmitted at a fourth speed, and
the third information bit stream distribution device (1-3) extracts, from the second transmission data included in the valid bit stream of the second information bit stream, some pieces of transmission data as fifth transmission data, outputs an information bit stream having a valid bit stream including the fifth transmission data and an invalid bit stream including dummy data as a fifth information bit stream in which the fifth transmission data is transmitted at a fifth speed, extracts, from the second transmission data, transmission data other than the fifth transmission data as sixth transmission data, and outputs an information bit stream having a valid bit stream including the sixth transmission data and an invalid bit stream including dummy data as a sixth information bit stream in which the sixth transmission data is transmitted at the sixth speed, and
wherein in each of the secondary information bit stream distribution devices,
the first information bit stream distribution device (1-1) acquires an information bit stream having a valid bit stream including transmission data and an invalid bit stream including dummy data, outputs the first information bit stream to an outside, and outputs the second information bit stream to a second information bit stream distribution device,
the second information bit stream distribution device (1-2) extracts, from second transmission data included in the valid bit stream of the second information bit stream, some pieces of transmission data as seventh transmission data, outputs an information bit stream having a valid bit stream including the seventh transmission data and an invalid bit stream including dummy data to the outside as a seventh information bit stream in which the seventh transmission data is transmitted at a seventh speed, extracts, from the second transmission data, transmission data other than the seventh transmission data as eighth transmission data, and outputs an eighth information bit stream having a valid bit stream including the eighth transmission data and an invalid bit stream including dummy data to a third information bit stream distribution device, and
the third information bit stream distribution device (1-3) extracts, from the eighth transmission data included in the valid bit stream of the eighth information bit stream, some pieces of transmission data as ninth transmission data, outputs an information bit stream having a valid bit stream including the ninth transmission data and an invalid bit stream including dummy data to the outside as a ninth information bit stream in which the ninth transmission data is transmitted at a ninth speed, extracts, from the eighth transmission data, transmission data other than the ninth transmission data as tenth transmission data, and outputs an information bit stream having a valid bit stream including the tenth transmission data and an invalid bit stream including dummy data to the outside as a tenth information bit stream in which the tenth transmission data is transmitted at a tenth speed, and
wherein the four secondary information bit stream distribution devices acquire the third information bit stream, the fourth information bit stream, the fifth information bit stream, and the sixth information bit stream output from the first information bit stream distribution device, respectively, and each outputs the seventh information bit stream, the ninth information bit stream, and the tenth information bit stream to a distribution matching circuit (5-1 to 5-4) as output information bit streams, and
the distribution matching circuit (5-1 to 5-4) performs probabilistic shaping of signal point on the output information bit streams and outputs the probabilistically shaped information bit streams.

2. An information bit stream distribution method in an optical communication system including
one information bit stream distribution device (3) as a primary information bit stream distribution device; and
at least four information bit stream distribution devices (4) as secondary information bit stream distribution devices,
the primary information bit stream distribution device comprising three information bit stream distribution devices (1-1, 1-2, 1-3) being first, second, and third information bit stream distribution devices, and
each of the secondary information bit stream distribution devices comprising three information bit stream distribution devices (1-1, 1-2, 1-3), being first, second, and third information bit stream distribution devices; the method comprising: by a first bit stream output unit (11) of each of the first, second and third information bit stream distribution devices (1-1, 1-2, 1-3), acquiring an information bit stream having a valid bit stream including transmission data and an invalid bit stream including dummy data, extracting, from the transmission data included in the valid bit stream of the information bit stream acquired by the first bit stream output unit, transmission data whose number of bits is represented by sb as first transmission data, and outputting, as a first information bit stream in which the first transmission data is transmitted at a first speed, an information bit stream having a valid bit stream including the first transmission data and an invalid bit stream including dummy data; and
by a second bit stream output unit (12) of each of the information bit stream distribution device (1-1, 1-2, 1-3), extracting, from the transmission data included in the valid bit stream of the information bit stream acquired by the first bit stream output unit, transmission data, whose number of bits is represented by st, other than the first transmission data as second transmission data, and outputting, as a second information bit stream in which the second transmission data is transmitted at a second speed, an information bit stream having a valid bit stream including the second transmission data and an invalid bit stream including dummy data,
wherein the number sb is determined according to the first speed at which the first transmission data is transmitted,
the number st is determined according to the second speed at which the second transmission data is transmitted,
the number sb increases as the first speed increases. and
the number st increases as the second speed increases; and
by the primary information bit stream distribution device,
the first information bit stream distribution device (1-1) acquiring the information bit stream having a valid bit stream including transmission data and an invalid bit stream including dummy data, outputting the first information bit stream to the second information bit stream distribution device, and outputting the second information bit stream to the third information bit stream distribution device,
the second information bit stream distribution device (1-2) extracting, from the first transmission data included in the valid bit stream of the first information bit stream, some pieces of transmission data as third transmission data, outputting an information bit stream having a valid bit stream including the third transmission data and an invalid bit stream including dummy data as a third information bit stream in which the third transmission data is transmitted at a third speed, extracting, from the first transmission data, transmission data other than the third transmission data as fourth transmission data, and outputting an information bit stream having a valid bit stream including the fourth transmission data and an invalid bit stream including dummy data as a fourth information bit stream in which the fourth transmission data is transmitted at a fourth speed, and
the third information bit stream distribution device (1-3) extracting, from the second transmission data included in the valid bit stream of the second information bit stream, some pieces of transmission data as fifth transmission data, outputting an information bit stream having a valid bit stream including the fifth transmission data and an invalid bit stream including dummy data as a fifth information bit stream in which the fifth transmission data is transmitted at a fifth speed, extracting, from the second transmission data, transmission data other than the fifth transmission data as sixth transmission data, and outputting an information bit stream having a valid bit stream including the sixth transmission data and an invalid bit stream including dummy data as a sixth information bit stream in which the sixth transmission data is transmitted at the sixth speed; and
by each of the secondary information bit stream distribution devices,
the first information bit stream distribution device (1-1) acquiring an information bit stream having a valid bit stream including transmission data and an invalid bit stream including dummy data, outputting the first information bit stream to an outside, and outputting the second information bit stream to a second information bit stream distribution device,
the second information bit stream distribution device (1-2) extracting, from second transmission data included in the valid bit stream of the second information bit stream, some pieces of transmission data as seventh transmission data, outputting an information bit stream having a valid bit stream including the seventh transmission data and an invalid bit stream including dummy data to the outside as a seventh information bit stream in which the seventh transmission data is transmitted at a seventh speed, extracting, from the second transmission data, transmission data other than the seventh transmission data as eighth transmission data, and outputting an eighth information bit stream having a valid bit stream including the eighth transmission data and an invalid bit stream including dummy data to a third information bit stream distribution device, and
the third information bit stream distribution device (1-3) extracting, from the eighth transmission data included in the valid bit stream of the eighth information bit stream, some pieces of transmission data as ninth transmission data, outputting an information bit stream having a valid bit stream including the ninth transmission data and an invalid bit stream including dummy data to the outside as a ninth information bit stream in which the ninth transmission data is transmitted at a ninth speed, extracting, from the eighth transmission data, transmission data other than the ninth transmission data as tenth transmission data, and outputting an information bit stream having a valid bit stream including the tenth transmission data and an invalid bit stream including dummy data to the outside as a tenth information bit stream in which the tenth transmission data is transmitted at a tenth speed; and
by the four secondary information bit stream distribution devices (4), acquiring the third information bit stream, the fourth information bit stream, the fifth information bit stream, and the sixth information bit stream output from the first information bit stream distribution device, respectively, and each outputting the seventh information bit stream, the ninth information bit stream, and the tenth information bit stream to a distribution matching circuit (5-1 to 5-4) as output information bit streams, and
by the distribution matching circuit (5-1 to 5-4), performing probabilistic shaping of signal point on the output information bit streams and outputting the probabilistically shaped information bit streams.

## Patentansprüche

1. Information-Bitstream-Wandlerschaltung (30) in einem optischen Kommunikationssystem, umfassend:
eine Information-Bitstream-Verteilungsvorrichtung (3) als eine primäre Information-Bitstream-Verteilungsvorrichtung; und
wenigstens vier Information-Bitstream-Verteilungsvorrichtungen (4) als sekundäre Information-Bitstream-Verteilungsvorrichtungen, wobei
die primäre Information-Bitstream-Verteilungsvorrichtung drei Information-Bitstream-Verteilungsvorrichtungen (1-1, 1-2, 1-3) umfasst, welche erste, zweite und dritte Information-Bitstream-Verteilungsvorrichtungen sind, und
jede der sekundären Information-Bitstream-Verteilungsvorrichtungen drei Information-Bitstream-Verteilungsvorrichtungen (1-1, 1-2, 1-3) umfasst, welche erste, zweite und dritte Information-Bitstream-Verteilungsvorrichtungen sind,
wobei jede der ersten, zweiten und dritten Information-Bitstream-Verteilungsvorrichtungen (1-1, 1-2, 1-3) umfasst:
eine erste Bitstream-Ausgabeeinheit (11) zum Aufnehmen eines Information-Bitstreams, welcher einen validen Bitstream, welcher Transmissionsdaten umfasst, und einen invaliden Bitstream aufweist, welcher Dummy-Daten umfasst, um aus den Transmissionsdaten, welche in dem validen Bitstream des Information-Bitstreams umfasst sind, welcher von der ersten Bitstream-Ausgabeeinheit (11) aufgenommen wird, Transmissionsdaten, deren Anzahl von Bits durch sb repräsentiert ist, als erste Transmissionsdaten zu extrahieren, und als einen ersten Information-Bitstream, in welchem die ersten Transmissionsdaten bei einer ersten Geschwindigkeit übertragen werden, einen Information-Bitstream auszugeben, welcher einen validen Bitstream, welcher die ersten Transmissionsdaten umfasst, und einen invaliden Bitstream aufweist, welcher Dummy-Daten umfasst; und eine zweite Bitstream-Ausgabeeinheit (12) zum Extrahieren aus den Transmissionsdaten, welche in dem validen Bitstream des Information-Bitstreams umfasst sind, welcher von der ersten Bitstream-Ausgabeeinheit (11) aufgenommen wird, von Transmissionsdaten, deren Anzahl von Bits durch st repräsentiert ist, welche verschieden von den ersten Transmissionsdaten sind, als zweite Transmissionsdaten, und als einen zweiten Information-Bitstream, in welchem die zweiten Transmissionsdaten bei einer zweiten Geschwindigkeit übertragen werden, einen Information-Bitstream auszugeben, welcher einen validen Bitstream, welcher die zweiten Transmissionsdaten umfasst, und einen invaliden Bitstream aufweist, welcher Dummy-Daten umfasst,
wobei die Anzahl sb gemäß der ersten Geschwindigkeit bestimmt wird, bei welcher die ersten Transmissionsdaten übertragen werden,
die Anzahl st gemäß der zweiten Geschwindigkeit bestimmt wird, bei welcher die zweiten Transmissionsdaten übertragen werden,
die Anzahl sb zunimmt, wenn die erste Geschwindigkeit zunimmt, und
die Anzahl st zunimmt, wenn die zweite Geschwindigkeit zunimmt, und
wobei in der primären Information-Bitstream-Verteilungsvorrichtung,
die erste Information-Bitstream-Verteilungsvorrichtung (1-1) den Information-Bitstream aufnimmt, welcher einen validen Bitstream, welcher Transmissionsdaten umfasst, und einen invaliden Bitstream aufweist, welcher Dummy-Daten umfasst, den ersten Information-Bitstream zu der zweiten Information-Bitstream-Verteilungsvorrichtung ausgibt und den zweiten Information-Bitstream zu der dritten Information-Bitstream-Verteilungsvorrichtung ausgibt,
die zweite Information-Bitstream-Verteilungsvorrichtung (1-2) aus den ersten Transmissionsdaten, welche in dem validen Bitstream des ersten Information-Bitstreams umfasst sind, einige Stücke von Transmissionsdaten als dritte Transmissionsdaten extrahiert, einen Information-Bitstream ausgibt, welcher einen validen Bitstream, welcher die dritten Transmissionsdaten umfasst, und einen invaliden Bitstream aufweist, welcher Dummy-Daten umfasst, als einen dritten Information-Bitstream, in welchem die dritten Transmissionsdaten bei einer dritten Geschwindigkeit übertragen werden, aus den ersten Transmissionsdaten Transmissionsdaten, welche verschieden von den dritten Transmissionsdaten sind, als vierte Transmissionsdaten extrahiert, und einen Information-Bitstream ausgibt, welcher einen validen Bitstream, welcher die vierten Transmissionsdaten umfasst, und einen invaliden Bitstream aufweist, welcher Dummy-Daten umfasst, als einen vierten Information-Bitstream, in welchem die vierten Transmissionsdaten bei einer vierten Geschwindigkeit übertragen werden, und
die dritte Information-Bitstream-Verteilungsvorrichtung (1-3) aus den zweiten Transmissionsdaten, welche in dem validen Bitstream des zweiten Information-Bitstreams umfasst sind, einige Stücke von Transmissionsdaten als fünfte Transmissionsdaten extrahiert, einen Information-Bitstream ausgibt, welcher einen validen Bitstream, welcher die fünften Transmissionsdaten umfasst, und einen invaliden Bitstream aufweist, welcher Dummy-Daten umfasst, als einen fünften Information-Bitstream, in welchem die fünften Transmissionsdaten bei einer fünften Geschwindigkeit übertragen werden, aus den zweiten Transmissionsdaten Transmissionsdaten, welche verschieden von den fünften Transmissionsdaten sind, als sechste Transmissionsdaten extrahiert, und einen Information-Bitstream ausgibt, welcher einen validen Bitstream, welcher die sechsten Transmissionsdaten umfasst, und einen invaliden Bitstream aufweist, welcher Dummy-Daten umfasst, als einen sechsten Information-Bitstream, in welchem die sechsten Transmissionsdaten bei der sechsten Geschwindigkeit übertragen werden, und
wobei in jeder der sekundären Information-Bitstream-Verteilungsvorrichtungen, die erste Information-Bitstream-Verteilungsvorrichtung (1-1) einen Information-Bitstream aufnimmt, welcher einen validen Bitstream, welcher Transmissionsdaten umfasst, und einen invaliden Bitstream aufweist, welcher Dummy-Daten umfasst, den ersten Information-Bitstream zu einer Außenseite ausgibt, und den zweiten Information-Bitstream zu einer zweiten Information-Bitstream-Verteilungsvorrichtung ausgibt,
die zweite Information-Bitstream-Verteilungsvorrichtung (1-2) aus zweiten Transmissionsdaten, welche in dem validen Bitstream des zweiten Information-Bitstreams umfasst sind, einige Stücke von Transmissionsdaten als siebte Transmissionsdaten extrahiert, einen Information-Bitstream, welcher einen validen Bitstream, welcher die siebten Transmissionsdaten umfasst, und einen invaliden Bitstream aufweist, welcher Dummy-Daten umfasst, zu der Außenseite als einen siebten Information-Bitstream ausgibt, in welchem die siebten Transmissionsdaten bei einer siebten Geschwindigkeit übertragen werden, aus den zweiten Transmissionsdaten Transmissionsdaten, welche von den siebten Transmissionsdaten verschieden sind, als achte Transmissionsdaten extrahiert, und einen achten Information-Bitstream, welcher einen validen Bitstream, welcher die achten Transmissionsdaten umfasst, und einen invaliden Bitstream aufweist, welcher Dummy-Daten umfasst, zu einer dritten Information-Bitstream-Verteilungsvorrichtung ausgibt, und
die dritte Information-Bitstream-Verteilungsvorrichtung (1-3) aus den achten Transmissionsdaten, welche in dem validen Bitstream des achten Information-Bitstreams umfasst sind, einige Stücke von Transmissionsdaten als neunte Transmissionsdaten extrahiert, einen Information-Bitstream, welcher einen validen Bitstream, welcher die neunten Transmissionsdaten umfasst, und einen invaliden Bitstream aufweist, welcher Dummy-Daten umfasst, zu der Außenseite als einen neunten Information-Bitstream ausgibt, in welchem die neunten Transmissionsdaten bei einer neunten Geschwindigkeit übertragen werden, aus den achten Transmissionsdaten Transmissionsdaten, welche von den neunten Transmissionsdaten verschieden sind, als zehnte Transmissionsdaten extrahiert, und einen Information-Bitstream, welcher einen validen Bitstream, welcher die zehnten Transmissionsdaten umfasst, und einen invaliden Bitstream aufweist, welcher Dummy-Daten umfasst, zu der Außenseite als einen zehnten Information-Bitstream ausgibt, in welchem die zehnten Transmissionsdaten bei einer zehnten Geschwindigkeit übertragen werden, und
wobei die vier sekundären Information-Bitstream-Verteilungsvorrichtungen den dritten Information-Bitstream, den vierten Information-Bitstream, den fünften Information-Bitstream und den sechsten Information-Bitstream aufnehmen, welche jeweils von der ersten Information-Bitstream-Verteilungsvorrichtung ausgegeben werden, und jede den siebten Information-Bitstream, den neunten Information-Bitstream und den zehnten Information-Bitstream zu einer Verteilung-Anpassungsschaltung (5-1 bis 5-4) als Ausgabeinformation-Bitstreams ausgibt, und die Verteilung-Anpassungsschaltung (5-1 bis 5-4) eine Wahrscheinlichkeitsformung eines Signalpunkts auf die Ausgabeinformation-Bitstreams durchführt und die wahrscheinlichkeitsgeformten Information-Bitstreams ausgibt.

2. Information-Bitstream-Verteilungsverfahren in einem optischen Kommunikationssystem, umfassend:
eine Information-Bitstream-Verteilungsvorrichtung (3) als eine primäre Information-Bitstream-Verteilungsvorrichtung; und
wenigstens vier Information-Bitstream-Verteilungsvorrichtungen (4) als sekundäre Information-Bitstream-Verteilungsvorrichtungen, wobei
die primäre Information-Bitstream-Verteilungsvorrichtung drei Information-Bitstream-Verteilungsvorrichtungen (1-1, 1-2, 1-3) umfasst, welche erste, zweite und dritte Information-Bitstream-Verteilungsvorrichtungen sind, und
jede der sekundären Information-Bitstream-Verteilungsvorrichtungen drei Information-Bitstream-Verteilungsvorrichtungen (1-1, 1-2, 1-3) umfasst, welche erste, zweite und dritte Information-Bitstream-Verteilungsvorrichtungen sind,
das Verfahren umfassend:
durch eine erste Bitstream-Ausgabeeinheit (11) von jeder aus den ersten, zweiten und dritten Information-Bitstream-Verteilungsvorrichtungen (1-1, 1-2, 1-3), Aufnehmen eines Information-Bitstreams, welcher einen validen Bitstream, welcher Transmissionsdaten umfasst, und einen invaliden Bitstream aufweist, welcher Dummy-Daten umfasst, Extrahieren aus den Transmissionsdaten, welche in dem validen Bitstream des Information-Bitstreams umfasst sind, welcher von der ersten Bitstream-Ausgabeeinheit aufgenommen wird, von Transmissionsdaten, deren Anzahl von Bits durch sb repräsentiert ist, als erste Transmissionsdaten, und Ausgeben als einen ersten Information-Bitstream, in welchem die ersten Transmissionsdaten bei einer ersten Geschwindigkeit übertragen werden, eines Information-Bitstreams, welcher einen validen Bitstream, welcher die ersten Transmissionsdaten umfasst, und einen invaliden Bitstream aufweist, welcher Dummy-Daten umfasst; und
durch eine zweite Bitstream-Ausgabeeinheit (12) von jeder der Information-Bitstream-Verteilungsvorrichtungen (1-1, 1-2, 1-3), Extrahieren aus den Transmissionsdaten, welche in dem validen Bitstream des Information-Bitstreams umfasst sind, welcher von der ersten Bitstream-Ausgabeeinheit aufgenommen wird, von Transmissionsdaten, deren Anzahl von Bits durch st repräsentiert ist, welche verschieden von den ersten Transmissionsdaten sind, als zweite Transmissionsdaten, und Ausgeben als einen zweiten Information-Bitstream, in welchem die zweiten Transmissionsdaten bei einer zweiten Geschwindigkeit übertragen werden, eines Information-Bitstreams, welcher einen validen Bitstream, welcher die zweiten Transmissionsdaten umfasst, und einen invaliden Bitstream aufweist, welcher Dummy-Daten umfasst,
wobei die Anzahl sb gemäß der ersten Geschwindigkeit bestimmt wird, bei welcher die ersten Transmissionsdaten übertragen werden,
die Anzahl st gemäß der zweiten Geschwindigkeit bestimmt wird, bei welcher die zweiten Transmissionsdaten übertragen werden,
die Anzahl sb zunimmt, wenn die erste Geschwindigkeit zunimmt, und
die Anzahl st zunimmt, wenn die zweite Geschwindigkeit zunimmt, und
wobei durch die erste primäre Information-Bitstream-Verteilungsvorrichtung, die erste Information-Bitstream-Verteilungsvorrichtung (1-1) den Information-Bitstream aufnimmt, welcher einen validen Bitstream, welcher Transmissionsdaten umfasst, und einen invaliden Bitstream aufweist, welcher Dummy-Daten umfasst, den ersten Information-Bitstream zu der zweiten Information-Bitstream-Verteilungsvorrichtung ausgibt und den zweiten Information-Bitstream zu der dritten Information-Bitstream-Verteilungsvorrichtung ausgibt,
die zweite Information-Bitstream-Verteilungsvorrichtung (1-2) aus den ersten Transmissionsdaten, welche in dem validen Bitstream des ersten Information-Bitstreams umfasst sind, einige Stücke von Transmissionsdaten als dritte Transmissionsdaten extrahiert, einen Information-Bitstream ausgibt, welcher einen validen Bitstream, welcher die dritten Transmissionsdaten umfasst, und einen invaliden Bitstream aufweist, welcher Dummy-Daten umfasst, als einen dritten Information-Bitstream, in welchem die dritten Transmissionsdaten bei einer dritten Geschwindigkeit übertragen werden, aus den ersten Transmissionsdaten Transmissionsdaten, welche verschieden von den dritten Transmissionsdaten sind, als vierte Transmissionsdaten extrahiert, und einen Information-Bitstream ausgibt, welcher einen validen Bitstream, welcher die vierten Transmissionsdaten umfasst, und einen invaliden Bitstream aufweist, welcher Dummy-Daten umfasst, als einen vierten Information-Bitstream, in welchem die vierten Transmissionsdaten bei einer vierten Geschwindigkeit übertragen werden, und
die dritte Information-Bitstream-Verteilungsvorrichtung (1-3) aus den zweiten Transmissionsdaten, welche in dem validen Bitstream des zweiten Information-Bitstreams umfasst sind, einige Stücke von Transmissionsdaten als fünfte Transmissionsdaten extrahiert, einen Information-Bitstream ausgibt, welcher einen validen Bitstream, welcher die fünften Transmissionsdaten umfasst, und einen invaliden Bitstream aufweist, welcher Dummy-Daten umfasst, als einen fünften Information-Bitstream, in welchem die fünften Transmissionsdaten bei einer fünften Geschwindigkeit übertragen werden, aus den zweiten Transmissionsdaten Transmissionsdaten, welche verschieden von den fünften Transmissionsdaten sind, als sechste Transmissionsdaten extrahiert, und einen Information-Bitstream ausgibt, welcher einen validen Bitstream, welcher die sechsten Transmissionsdaten umfasst, und einen invaliden Bitstream aufweist, welcher Dummy-Daten umfasst, als einen sechsten Information-Bitstream, in welchem die sechsten Transmissionsdaten bei einer sechsten Geschwindigkeit übertragen werden, und
wobei durch jede der sekundären Information-Bitstream-Verteilungsvorrichtungen, die erste Information-Bitstream-Verteilungsvorrichtung (1-1) einen Information-Bitstream aufnimmt, welcher einen validen Bitstream, welcher Transmissionsdaten umfasst, und einen invaliden Bitstream aufweist, welcher Dummy-Daten umfasst, den ersten Information-Bitstream zu einer Außenseite ausgibt, und den zweiten Information-Bitstream zu einer zweiten Information-Bitstream-Verteilungsvorrichtung ausgibt,
die zweite Information-Bitstream-Verteilungsvorrichtung (1-2) aus zweiten Transmissionsdaten, welche in dem validen Bitstream des zweiten Information-Bitstreams umfasst sind, einige Stücke von Transmissionsdaten als siebte Transmissionsdaten extrahiert, einen Information-Bitstream, welcher einen validen Bitstream, welcher die siebten Transmissionsdaten umfasst, und einen invaliden Bitstream aufweist, welcher Dummy-Daten umfasst, zu der Außenseite als einen siebten Information-Bitstream ausgibt, in welchem die siebten Transmissionsdaten bei einer siebten Geschwindigkeit übertragen werden, aus den zweiten Transmissionsdaten Transmissionsdaten, welche von den siebten Transmissionsdaten verschieden sind, als achte Transmissionsdaten extrahiert, und einen achten Information-Bitstream, welcher einen validen Bitstream, welcher die achten Transmissionsdaten umfasst, und einen invaliden Bitstream aufweist, welcher Dummy-Daten umfasst, zu einer dritten Information-Bitstream-Verteilungsvorrichtung ausgibt, und
die dritte Information-Bitstream-Verteilungsvorrichtung (1-3) aus den achten Transmissionsdaten, welche in dem validen Bitstream des achten Information-Bitstreams umfasst sind, einige Stücke von Transmissionsdaten als neunte Transmissionsdaten extrahiert, einen Information-Bitstream, welcher einen validen Bitstream, welcher die neunten Transmissionsdaten umfasst, und einen invaliden Bitstream aufweist, welcher Dummy-Daten umfasst, zu der Außenseite als einen neunten Information-Bitstream ausgibt, in welchem die neunten Transmissionsdaten bei einer neunten Geschwindigkeit übertragen werden, aus den achten Transmissionsdaten Transmissionsdaten, welche von den neunten Transmissionsdaten verschieden sind, als zehnte Transmissionsdaten extrahiert, und einen Information-Bitstream, welcher einen validen Bitstream, welcher die zehnten Transmissionsdaten umfasst, und einen invaliden Bitstream aufweist, welcher Dummy-Daten umfasst, zu der Außenseite als einen zehnten Information-Bitstream ausgibt, in welchem die zehnten Transmissionsdaten bei einer zehnten Geschwindigkeit übertragen werden, und
durch die vier sekundären Information-Bitstream-Verteilungsvorrichtungen (4), Aufnehmen des dritten Information-Bitstreams, des vierten Information-Bitstreams, des fünften Information-Bitstreams und des sechsten Information-Bitstreams, welche jeweils von der ersten Information-Bitstream-Verteilungsvorrichtung ausgegeben werden, und jede den siebten Information-Bitstream, den neunten Information-Bitstream und den zehnten Information-Bitstream zu einer Verteilung-Anpassungsschaltung (5-1 bis 5-4) als Ausgabeinformation-Bitstreams ausgibt, und durch die Verteilung-Anpassungsschaltung (5-1 bis 5-4), Durchführen einer Wahrscheinlichkeitsformung eines Signalpunkts auf die Ausgabeinformation-Bitstreams und Ausgeben der wahrscheinlichkeitsgeformten Information-Bitstreams.

## Revendications

1. Circuit de conversion de flux binaires d'informations (30) dans un système de communication optique comprenant :
un dispositif de distribution de flux binaires d'informations (3) en tant que dispositif de distribution de flux binaires d'informations primaire ; et
au moins quatre dispositifs de distribution de flux binaires d'informations (4) en tant que dispositifs de distribution de flux binaires d'informations secondaires, dans lequel le dispositif de distribution de flux binaires d'informations primaire comprend trois dispositifs de distribution de flux binaires d'informations (1-1, 1-2, 1-3) qui sont des premier, deuxième et troisième dispositifs de distribution de flux binaires d'informations, et chacun des dispositifs de distribution de flux binaires d'informations secondaires comprend trois dispositifs de distribution de flux binaires d'informations (1-1, 1-2, 1-3), qui sont des premier, deuxième et troisième dispositifs de distribution de flux binaires d'informations,
dans lequel chacun des premier, deuxième et troisième dispositifs de distribution de flux binaires d'informations (1-1, 1-2, 1-3) comprend :
une première unité de sortie de flux binaires (11) pour acquérir un flux binaire d'informations ayant un flux binaire valide comportant des données d'émission et un flux binaire non valide comportant des données factices, pour extraire, des données d'émission comprises dans le flux binaire valide du flux binaire d'informations acquis par la première unité de sortie de flux binaires (11), des données d'émission dont le nombre de bits est représenté par sb en tant que premières données d'émission, et pour sortir, en tant que premier flux binaire d'informations dans lequel les premières données d'émission sont émises à une première vitesse, un flux binaire d'informations ayant un flux binaire valide comportant les premières données d'émission et un flux binaire non valide comportant des données factices ; et
une deuxième unité de sortie de flux binaires (12) pour extraire, des données d'émission comprises dans le flux binaire valide du flux binaire d'informations acquis par la première unité de sortie de flux binaires (11), des données d'émission, dont le nombre de bits est représenté par st, autres que les premières données d'émission, en tant que deuxièmes données d'émission, et pour sortir, en tant que deuxième flux binaire d'informations dans lequel les deuxièmes données d'émission sont émises à une deuxième vitesse, un flux binaire d'informations ayant un flux binaire valide comportant les deuxièmes données d'émission et un flux binaire non valide comportant des données factices,
dans lequel le nombre sb est déterminé conformément à la première vitesse à laquelle les premières données d'émission sont émises,
le nombre st est déterminé conformément à la deuxième vitesse à laquelle les deuxièmes données d'émission sont émises,
le nombre sb augmente à mesure que la première vitesse augmente, et
le nombre st augmente à mesure que la deuxième vitesse augmente, et
dans lequel, dans le dispositif de distribution de flux binaires d'informations primaire, le premier dispositif de distribution de flux binaires d'informations (1-1) acquiert le flux binaire d'informations ayant un flux binaire valide comportant des données d'émission et un flux binaire non valide comportant des données factices, sort le premier flux binaire d'informations vers le deuxième dispositif de distribution de flux binaires d'informations, et sort le deuxième flux binaire d'informations vers le troisième dispositif de distribution de flux binaires d'informations,
le deuxième dispositif de distribution de flux binaires d'informations (1-2) extrait, des premières données d'émission comprises dans le flux binaire valide du premier flux binaire d'informations, certaines données d'émission en tant que troisièmes données d'émission, sort un flux binaire d'informations ayant un flux binaire valide comportant les troisièmes données d'émission et un flux binaire non valide comportant des données factices en tant que troisième flux binaire d'informations dans lequel les troisièmes données d'émission sont émises à une troisième vitesse, extrait, des premières données d'émission, des données d'émission autres que les troisièmes données d'émission en tant que quatrièmes données d'émission, et sort un flux binaire d'informations ayant un flux binaire valide comportant les quatrièmes données d'émission et un flux binaire non valide comportant des données factices en tant que quatrième flux binaire d'informations dans lequel les quatrièmes données d'émission sont émises à une quatrième vitesse, et
le troisième dispositif de distribution de flux binaires d'informations (1-3) extrait, des deuxièmes données d'émission comprises dans le flux binaire valide du deuxième flux binaire d'informations, certaines données d'émission en tant que cinquièmes données d'émission, sort un flux binaire d'informations ayant un flux binaire valide comportant les cinquièmes données d'émission et un flux binaire non valide comportant des données factices en tant que cinquième flux binaire d'informations dans lequel les cinquièmes données d'émission sont émises à une cinquième vitesse, extrait, des deuxièmes données d'émission, des données d'émission autres que les cinquièmes données d'émission en tant que sixièmes données d'émission, et sort un flux binaire d'informations ayant un flux binaire valide comportant les sixièmes données d'émission et un flux binaire non valide comportant des données factices en tant que sixième flux binaire d'informations dans lequel les sixièmes données d'émission sont émises à la sixième vitesse, et
dans lequel, dans chacun des dispositifs de distribution de flux binaires d'informations secondaires,
le premier dispositif de distribution de flux binaires d'informations (1-1) acquiert un flux binaire d'informations ayant un flux binaire valide comportant des données d'émission et un flux binaire non valide comportant des données factices, sort le premier flux binaire d'informations vers l'extérieur, et sort le deuxième flux binaire d'informations vers un deuxième dispositif de distribution de flux binaires d'informations,
le deuxième dispositif de distribution de flux binaires d'informations (1-2) extrait, de deuxièmes données d'émission comprises dans le flux binaire valide du deuxième flux binaire d'informations, certaines données d'émission en tant que septièmes données d'émission, sort un flux binaire d'informations ayant un flux binaire valide comportant les septièmes données d'émission et un flux binaire non valide comportant des données factices vers l'extérieur en tant que septième flux binaire d'informations dans lequel les septièmes données d'émission sont émises à une septième vitesse, extrait, des deuxièmes données d'émission, des données d'émission autres que les septièmes données d'émission en tant que huitièmes données d'émission, et sort un huitième flux binaire d'informations ayant un flux binaire valide comportant les huitièmes données d'émission et un flux binaire non valide comportant des données factices vers un troisième dispositif de distribution de flux binaires d'informations, et
le troisième dispositif de distribution de flux binaires d'informations (1-3) extrait, des huitièmes données d'émission comprises dans le flux binaire valide du huitième flux binaire d'informations, certaines données d'émission en tant que neuvièmes données d'émission, sort un flux binaire d'informations ayant un flux binaire valide comportant les neuvièmes données d'émission et un flux binaire non valide comportant des données factices vers l'extérieur en tant que neuvième flux binaire d'informations dans lequel les neuvièmes données d'émission sont émises à une neuvième vitesse, extrait, des huitièmes données d'émission, des données d'émission autres que les neuvièmes données d'émission en tant que dixièmes données d'émission, et sort un flux binaire d'informations ayant un flux binaire valide comportant les dixièmes données d'émission et un flux binaire non valide comportant des données factices vers l'extérieur en tant que dixième flux binaire d'informations dans lequel les dixièmes données d'émission sont émises à une dixième vitesse, et
dans lequel les quatre dispositifs de distribution de flux binaires d'informations secondaires acquièrent le troisième flux binaire d'informations, le quatrième flux binaire d'informations, le cinquième flux binaire d'informations et le sixième flux binaire d'informations sortis du premier dispositif de distribution de flux binaires d'informations, respectivement, et chacun sort le septième flux binaire d'informations, le neuvième flux binaire d'informations et le dixième flux binaire d'informations vers un circuit de correspondance de distribution (5-1 à 5-4) en tant que flux binaires d'informations de sortie, et
le circuit de correspondance de distribution (5-1 à 5-4) réalise une mise en forme probabiliste d'un point de signal sur les flux binaires d'informations de sortie et sort les flux binaires d'informations après mise en forme probabiliste.

2. Procédé de distribution de flux binaires d'informations dans un système de communication optique comportant un dispositif de distribution de flux binaires d'informations (3) en tant que dispositif de distribution de flux binaires d'informations primaire ; et
au moins quatre dispositifs de distribution de flux binaires d'informations (4) en tant que dispositifs de distribution de flux binaires d'informations secondaires,
le dispositif de distribution de flux binaires d'informations primaire comprenant trois dispositifs de distribution de flux binaires d'informations (1-1, 1-2, 1-3) qui sont des premier, deuxième et troisième dispositifs de distribution de flux binaires d'informations, et
chacun des dispositifs de distribution de flux binaires d'informations secondaires comprenant trois dispositifs de distribution de flux binaires d'informations (1-1, 1-2, 1-3), qui sont des premier, deuxième et troisième dispositifs de distribution de flux binaires d'informations ; le procédé comprenant :
par une première unité de sortie de flux binaires (11) de chacun des premier, deuxième et troisième dispositifs de distribution de flux binaires d'informations (1-1, 1-2, 1-3), l'acquisition d'un flux binaire d'informations ayant un flux binaire valide comportant des données d'émission et un flux binaire non valide comportant des données factices, l'extraction, des données d'émission comprises dans le flux binaire valide du flux binaire d'informations acquis par la première unité de sortie de flux binaires, de données d'émission dont le nombre de bits est représenté par sb en tant que premières données d'émission, et la sortie, en tant que premier flux binaire d'informations dans lequel les premières données d'émission sont émises à une première vitesse, d'un flux binaire d'informations ayant un flux binaire valide comportant les premières données d'émission et un flux binaire non valide comportant des données factices ; et par une deuxième unité de sortie de flux binaires (12) de chacun des dispositifs de distribution de flux binaires d'informations (1-1, 1-2, 1-3), l'extraction, des données d'émission comprises dans le flux binaire valide du flux binaire d'informations acquis par la première unité de sortie de flux binaires, de données d'émission, dont le nombre de bits est représenté par st, autres que les premières données d'émission en tant que deuxièmes données d'émission, et la sortie, en tant que deuxième flux binaire d'informations dans lequel les deuxièmes données d'émission sont émises à une deuxième vitesse, d'un flux binaire d'informations ayant un flux binaire valide comportant les deuxièmes données d'émission et un flux binaire non valide comportant des données factices,
dans lequel le nombre sb est déterminé conformément à la première vitesse à laquelle les premières données d'émission sont émises,
le nombre st est déterminé conformément à la deuxième vitesse à laquelle les deuxièmes données d'émission sont émises,
le nombre sb augmente à mesure que la première vitesse augmente, et
le nombre st augmente à mesure que la deuxième vitesse augmente ; et
par le dispositif de distribution de flux binaires d'informations primaire,
le premier dispositif de distribution de flux binaires d'informations (1-1) acquiert le flux binaire d'informations ayant un flux binaire valide comportant des données d'émission et un flux binaire non valide comportant des données factices, sort le premier flux binaire d'informations vers le deuxième dispositif de distribution de flux binaires d'informations, et sort le deuxième flux binaire d'informations vers le troisième dispositif de distribution de flux binaires d'informations,
le deuxième dispositif de distribution de flux binaires d'informations (1-2) extrait, des premières données d'émission comprises dans le flux binaire valide du premier flux binaire d'informations, certaines données d'émission en tant que troisièmes données d'émission, sort un flux binaire d'informations ayant un flux binaire valide comportant les troisièmes données d'émission et un flux binaire non valide comportant des données factices en tant que troisième flux binaire d'informations dans lequel les troisièmes données d'émission sont émises à une troisième vitesse, extrait, des premières données d'émission, des données d'émission autres que les troisièmes données d'émission en tant que quatrièmes données d'émission, et sort un flux binaire d'informations ayant un flux binaire valide comportant les quatrièmes données d'émission et un flux binaire non valide comportant des données factices en tant que quatrième flux binaire d'informations dans lequel les quatrièmes données d'émission sont émises à une quatrième vitesse, et
le troisième dispositif de distribution de flux binaires d'informations (1-3) extrait, des deuxièmes données d'émission comprises dans le flux binaire valide du deuxième flux binaire d'informations, certaines données d'émission en tant que cinquièmes données d'émission, sort un flux binaire d'informations ayant un flux binaire valide comportant les cinquièmes données d'émission et un flux binaire non valide comportant des données factices en tant que cinquième flux binaire d'informations dans lequel les cinquièmes données d'émission sont émises à une cinquième vitesse, extrait, des deuxièmes données d'émission, des données d'émission autres que les cinquièmes données d'émission en tant que sixièmes données d'émission, et sort un flux binaire d'informations ayant un flux binaire valide comportant les sixièmes données d'émission et un flux binaire non valide comportant des données factices en tant que sixième flux binaire d'informations dans lequel les sixièmes données d'émission sont émises à la sixième vitesse ; et
par chacun des dispositifs de distribution de flux binaires d'informations secondaires, le premier dispositif de distribution de flux binaires d'informations (1-1) acquiert un flux binaire d'informations ayant un flux binaire valide comportant des données d'émission et un flux binaire non valide comportant des données factices, sort le premier flux binaire d'informations vers l'extérieur, et sort le deuxième flux binaire d'informations vers un deuxième dispositif de distribution de flux binaires d'informations,
le deuxième dispositif de distribution de flux binaires d'informations (1-2) extrait, de deuxièmes données d'émission comprises dans le flux binaire valide du deuxième flux binaire d'informations, certaines données d'émission en tant que septièmes données d'émission, sort un flux binaire d'informations ayant un flux binaire valide comportant les septièmes données d'émission et un flux binaire non valide comportant des données factices vers l'extérieur en tant que septième flux binaire d'informations dans lequel les septièmes données d'émission sont émises à une septième vitesse, extrait, des deuxièmes données d'émission, des données d'émission autres que les septièmes données d'émission en tant que huitièmes données d'émission, et sort un huitième flux binaire d'informations ayant un flux binaire valide comportant les huitièmes données d'émission et un flux binaire non valide comportant des données factices vers un troisième dispositif de distribution de flux binaires d'informations, et
le troisième dispositif de distribution de flux binaires d'informations (1-3) extrait, des huitièmes données d'émission comprises dans le flux binaire valide du huitième flux binaire d'informations, certaines données d'émission en tant que neuvièmes données d'émission, sort un flux binaire d'informations ayant un flux binaire valide comportant les neuvièmes données d'émission et un flux binaire non valide comportant des données factices vers l'extérieur en tant que neuvième flux binaire d'informations dans lequel les neuvièmes données d'émission sont émises à une neuvième vitesse, extrait, des huitièmes données d'émission, des données d'émission autres que les neuvièmes données d'émission en tant que dixièmes données d'émission, et sort un flux binaire d'informations ayant un flux binaire valide comportant les dixièmes données d'émission et un flux binaire non valide comportant des données factices vers l'extérieur en tant que dixième flux binaire d'informations dans lequel les dixièmes données d'émission sont émises à une dixième vitesse ; et
par les quatre dispositifs de distribution de flux binaires d'informations secondaires (4), l'acquisition du troisième flux binaire d'informations, du quatrième flux binaire d'informations, du cinquième flux binaire d'informations et du sixième flux binaire d'informations sortis du premier dispositif de distribution de flux binaires d'informations, respectivement, et par chacun de ceux-ci, la sortie du septième flux binaire d'informations, du neuvième flux binaire d'informations et du dixième flux binaire d'informations vers un circuit de correspondance de distribution (5-1 à 5-4) en tant que flux binaires d'informations de sortie, et par le circuit de correspondance de distribution (5-1 à 5-4), la réalisation d'une mise en forme probabiliste d'un point de signal sur les flux binaires d'informations de sortie et la sortie des flux binaires d'informations après mise en forme probabiliste.
